(19) **Europäisches Patentamt**
**European Patent Office**
**Office européen des brevets**

(11) **EP 1 818 706 A1**

(12) **EUROPEAN PATENT APPLICATION**
published in accordance with Art. 158(3) EPC

(43) Date of publication:
**15.08.2007 Bulletin 2007/33**

(51) Int Cl.:
**G02B 13/00** (2006.01)   **G02B 3/02** (2006.01)
**G02B 13/18** (2006.01)   **G02F 1/13357** (2006.01)
**H01L 33/00** (2006.01)

(21) Application number: **05811782.1**

(22) Date of filing: **02.12.2005**

(86) International application number:
**PCT/JP2005/022215**

(87) International publication number:
**WO 2006/059728 (08.06.2006 Gazette 2006/23)**

(84) Designated Contracting States:
**DE FR GB**

(30) Priority: **03.12.2004 JP 2004352027**
**28.04.2005 JP 2005133677**
**08.09.2005 JP 2005260908**

(71) Applicant: **Sony Corporation**
**Minato-ku**
**Tokyo 108-0075 (JP)**

(72) Inventors:
 • **NADA, Naoji,**
 **c/o SONY CORPORATION**
 **Tokyo 1410001 (JP)**
 • **YOSHIDA, Tetsuyuki,**
 **c/o SONY CORPORATION**
 **Tokyo 1410001 (JP)**

 • **UEDA, Mitsunori, c/o SONY CORPORATION**
 **Tokyo 1410001 (JP)**
 • **TOMIOKA, Satoshi,**
 **c/o SONY CORPORATION**
 **Tokyo 1410001 (JP)**
 • **OSAKO, Junichi,**
 **c/o SONY CORPORATION**
 **Tokyo 1410001 (JP)**
 • **KUBOTA, Shigeo,**
 **c/o SONY CORPORATION**
 **Tokyo 1410001 (JP)**

(74) Representative: **Müller, Frithjof E.**
**Müller Hoffmann Partner**
**Patentanwälte**
**Innere Wiener Strasse 17**
**D-81667 München (DE)**

(54) **LIGHT PICKUP LENS, LIGHT EMITTING ELEMENT ASSEMBLY, SURFACE LIGHT SOURCE DEVICE, AND COLOR LIQUID CRYSTAL DISPLAY UNIT ASSEMBLY**

(57)     There is provided a lens formed from a circular bottom face (11), lateral face (14) and top face (15) and having a surface light source (13) of a finite size disposed at the center of the bottom face (11). The top face (15) is an aspheric surface rotational symmetric with respect to a z-axis and which totally reflects a part of a component, whose polar angle is smaller than a polar angle $\Theta_0$ at the intersection between the lateral face (14) and top face (15), of light emitted from the surface light source (13). The lateral face (14) is an aspheric surface rotational symmetric with respect to the z-axis and pervious to a component, whose polar angle is larger than the polar angle $\Theta_0$, and component, totally reflected at the top face (15), of the light emitted from the surface light source (13). A function $r = f_s(z)$ where z is a variable representing the lateral face (14) increases monotonously as the variable z decreases in a closed zone defined by $0 \leq z \leq z_1$ (z-coordinate of an intersection between the lateral face (14) and top face (15)), and has at least one point where a absolute value $|d^2r/dz^2|$ is maximum in the closed zone.

**FIG.1**

**Description**

Technical Field

The present invention relates to a light-emission lens, light-emitting element assembly including the light-emission lens, surface light source device including the light emitting device, and a color liquid crystal display assembly including the surface light source device.

This application claims the priority of the Japanese Patent Application No. 2004-352027 filed in the Japanese Patent Office on December 3, 2004, Japanese Patent Application No. 2005-133677 filed in the Japanese Patent Office on April 28, 2005 and Japanese Patent Application No. 2005-260908 filed in the Japanese Patent Office on September 8, 2005, the entireties of which are incorporated by reference herein.

Background Art

As a typical color liquid crystal display assembly, there is well known the color liquid crystal display assembly including a color liquid crystal display in which two panels each formed from a transparent glass substrate having transparent electrodes, alignment layers, etc. deposited thereon are superimposed on each other with such elements on the glass substrates being opposite to each other and a liquid crystal material is sandwiched between the panels and a surface light source device provided below (in z-axial direction) of the color crystal liquid display to supply light to the color liquid crystal display. Also, as a surface light source device, there is well known the surface light source device to be provided directly under the color liquid crystal display. This surface light source device will be referred to as "direct-underlying type surface light source device" hereunder.

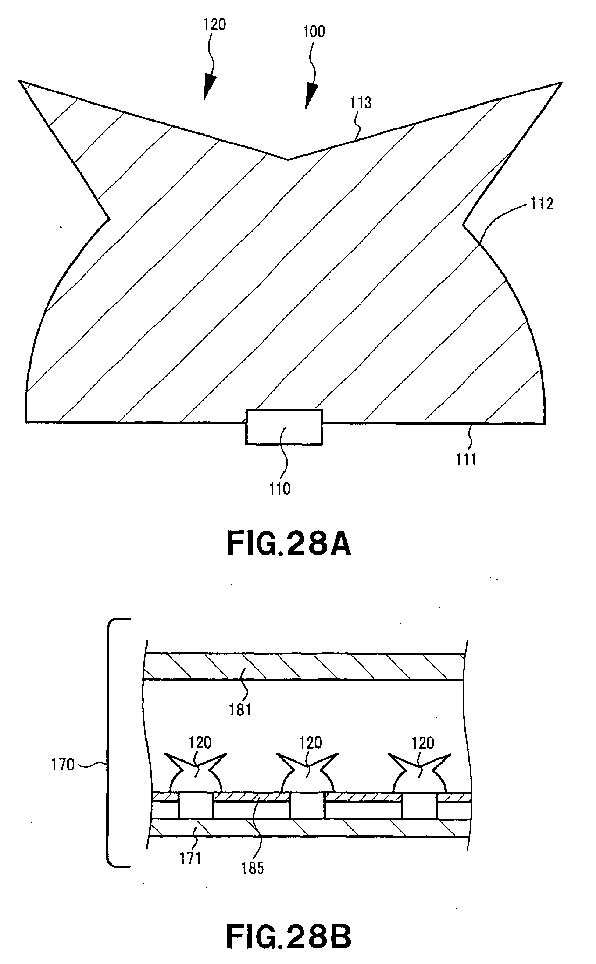

Referring now to FIG. 28B, there is schematically shown the concept of a conventional direct-underlying type surface light source device. FIG. 28B, the reference numeral 170 indicates the conventional direct-underlying type surface light source device. As shown, the direct-underlying type light source device 170 includes light sources 120 disposed inside a housing 171, a reflecting member 185 to reflect light from the light sources 120 upward and a diffusion plate 181 installed in an opening in the housing 171 located above the light sources 120 to allow the light emitted from the light sources 120 and reflected light from the reflecting member 185 to pass by while diffusing the light. The light sources 120 include light emitting diodes having a red color as one of its emission spectra, ones having a green color as one of its emission spectra and ones having a blue color as one of its emission spectra, and mixes light emitted from these light emitting diodes to provide white light as illuminating light. It should be noted that light emission including the red color as one of the emission spectra, light emission including the green color as one of the emission spectra and light emission including the blue color as one of the emission spectra will be referred to as "red light emission", "green light emission" and "blue light emission", respectively, hereunder. Also it should be noted that the light emitting diode that emits red light as one of its emission spectra, one that emits green light as one of its emission spectra and one that emits blue light as one of its emission spectra will be referred to as "red-light emitting diode", "green-light emitting diode" and "blue-light emitting diode", respectively, hereunder wherever appropriate.

In case light emitted from the light emitting diodes is guided for direct incidence upon the color liquid crystal display positioned in a higher position, namely, in case light is emitted from the light emitting diodes only in the x-axial direction, illuminance of the surface light source device will be nonuniform. Therefore, a two-dimensional emission system has been proposed in the Nikkei Electronics, Vol. 889, p. 128, December 20, 2004 (will be referred to as "Document 1" hereunder), for example, in which a light emitting diode assembly including a light emitting diode 110 and a lens 100 installed on the light emitting diode 110 is used as each of the light sources 120 and the light emitted from the light emitting diode 110 is totally reflected at a top face 113 of the lens 100 to go mainly in the horizontal direction of the lens 100, as shown in the conceptual diagram in FIG. 28A. It should be noted that in FIG. 28A, the reference numeral 111 indicates a bottom face of the lens 100 and 112 indicates a side face of the lens 100.

It should also be noted that the lens 100 in the light emitting diode assembly disclosed in the Document 1 is made with the molding technique such as injection molding, casting or the like. Since the lens 100 shown in FIG 28A is complicated in shape, however, it cannot be produced with a high throughput (disadvantageously, a lens cannot easily be taken out of an injection-molding die assembly by opening the latter), and a defect such as cracking is likely to occur in the lens 100 being taken out of the molding die assembly. Also, the top face 113 of the lens 100 is lowest at the center thereof and thus it extends upward and outward, so that the central portion of the top face 113 is likely to vary in shape from one lens to another.

It is therefore preferable to provide a lens massively producible, not likely to be cracked during the production and having a structure not likely to vary in shape from one lens to another during the mass production, a light-emitting element assembly including the lens, a surface light source device including the light-emitting element assembly and a color liquid crystal display assembly including the surface light source device.

Disclosure of the Invention

According to an embodiment in a first mode of the present invention, there is provided a lens formed from circular bottom, lateral and top faces and having a surface light source of a finite size provided at the center of the bottom face thereof.

According to another embodiment in the first mode of the present invention, there is also provided a light-emitting element assembly including a lens formed from circular bottom, lateral and top faces, and a surface light source formed from a light emitting element provided at the center of the bottom face of the lens.

According to another embodiment in the first mode of the present invention, there is also provided a surface light source device including a plurality of light-emitting element assemblies to emit red light, a plurality of light-emitting element assemblies to emit green light and a plurality of light-emitting element assemblies to emit blue light, each of the light-emitting element assemblies including a lens formed from circular bottom, lateral and top faces and a surface light source formed from a light emitting element provided at the center of the bottom face of the lens.

According to another mode in the first mode of the present invention, there is also provided a color liquid crystal display assembly including a transparent or semitransparent type color liquid crystal display and a surface light source device to backlight the color liquid crystal display (more specifically, a direct-underlying surface light source device), the surface light source device including a plurality of light-emitting element assemblies to emit red light, a plurality of light-emitting element assemblies to emit green light and a plurality of light-emitting element assemblies to emit blue light, and each of the light-emitting element assemblies including a lens formed from circular bottom, lateral and top faces and having a surface light source formed from a light emitting element provided at the center of the bottom face thereof.

In the lens and that included in the light-emitting element assembly, surface light source device or color liquid crystal display assembly, all embodied in the first mode (each of them will generically be referred to simply as "first-mode embodiment of the present invention" wherever appropriate hereunder), in a cylindrical coordinate $(r, \phi, z)$ assumed for the lens and of which the origin is the center of the bottom face and z-axis is a normal line passing through the center of the bottom face, the top face being an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and the lateral face being an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source, a function $r = f_s(z)$ where $z$ is a variable representing the aspheric lateral face increasing monotonously as the variable $z$ decreasing in a closed zone defined by $0 \le z \le z_1$ when the z-coordinate of the intersection between the lateral and top faces is $z_1$, and having at least one point where an absolute value $|Id^2r/dz^2|$ of a second-order differential coefficient of the variable $z$ takes a maximum value in the closed zone.

According to an embodiment in a second mode of the present invention, there is provided a lens formed from circular bottom, lateral and top faces and having a surface light source of a finite size provided at the center of the bottom face thereof.

According to another embodiment in the second mode of the present invention, there is also provided a light-emitting element assembly including a lens formed from circular bottom, lateral and top faces, and a surface light source formed from a light emitting element provided at the center of the bottom face of the lens.

According to another embodiment in the second mode of the present invention, there is also provided a surface light source device including a plurality of light-emitting element assemblies to emit red light, a plurality of light-emitting element assemblies to emit green light and a plurality of light-emitting element assemblies to emit blue light, each of the light-emitting element assemblies including a lens formed from circular bottom, lateral and top faces and a surface light source formed from a light emitting element provided at the center of the bottom face of the lens.

According to another mode in the second mode of the present invention, there is also provided a color liquid crystal display assembly including a transparent or semitransparent type color liquid crystal display and a surface light source device to backlight the color liquid crystal display (more specifically, a direct-underlying surface light source device), the surface light source device including a plurality of light-emitting element assemblies to emit red light, a plurality of light-emitting element assemblies to emit green light and a plurality of light-emitting element assemblies to emit blue light, and each of the light-emitting element assemblies including a lens formed from bottom, lateral and top faces and having a surface light source formed from a light emitting element provided at the center of the bottom face of the lens.

In the lens and that included in the light-emitting element assembly, surface light source device or color liquid crystal display assembly, all embodied in the second mode (each of them will generically be referred to simply as "second-mode embodiment of the present invention" hereunder wherever appropriate), in a cylindrical coordinate $(r, \phi, z)$ assumed for the lens and of which the origin is the center of the bottom face and z-axis is a normal line passing through the center of the bottom face, the top face is an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and the lateral face is an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source.

In the first- or second-mode embodiment of the present invention, the emitted light component is projected to outside from an inner portion of the top face which is to totally reflect a part of the emitted light component whose polar angle is smaller than polar angle $\Theta_0$ at the intersection between the lateral and top faces. The top-face portion to totally reflect the emitted light component will expediently be referred to as "total-reflecting top- face portion" or "first top-face portion" hereunder, while the inner top-face portion from which the emitted light component is projected to outside will expediently be referred to as "emitted-light emitting top-face portion" hereunder.

According to an embodiment in a third mode of the present invention, there is provided a lens formed from circular bottom, lateral and top faces and having a light emitting element provided at center of the bottom face thereof.

According to another embodiment in the third mode of the present invention, there is also provided a light-emitting element assembly including a lens formed from circular bottom, lateral and top faces and a light emitting element provided at the center of the bottom face of the lens.

According to another embodiment in the third mode of the present invention, there is also provided a surface light source device, more specifically, a surface light source device to backlight a transparent or semitransparent type color liquid crystal display, including a plurality of light-emitting element assemblies to emit red light, a plurality of light-emitting element assemblies to emit green light and a plurality of light-emitting element assemblies to emit blue light, each of the light-emitting element assemblies including a lens having circular bottom, lateral and top faces and a light emitting element provided at the center of the bottom face of the lens.

According to another mode in the third mode of the present invention, there is also provided a color liquid crystal display assembly including a transparent or semitransparent type color liquid crystal display and a surface light source device to backlight the color liquid crystal display (more specifically, a direct-underlying surface light source device), the surface light source device including a plurality of light-emitting element assemblies to emit red light, a plurality of light-emitting element assemblies to emit green light and a plurality of light-emitting element assemblies to emit blue light, and each of the light-emitting element assemblies including a lens formed from circular bottom, lateral and top faces and a light emitting element provided at the center of the bottom face of the lens.

In the lens and that included in the light-emitting element assembly, surface light source device or color liquid crystal display assembly, all embodied in the third mode (each of them will generically be referred to simply as "third-mode embodiment of the present invention" wherever appropriate hereunder), the lateral face of the lens is a curved surface convexed outwardly and symmetric with respect to an axis of revolution which is an axis passing through the center point of the bottom face and perpendicular to the bottom face, the top face is a curved surface convexed toward the bottom face and symmetric with respect to the axis of revolution, and on the assumption that the cone angle of a first virtual cone having the vertex thereof defined by the center point and being tangent to the top face is $\Omega_1$ and the cone angle (solid angle) of a second virtual cone having the vertex thereof defined by the center point and being tangent to the top face is $\Omega_2$, a component, existing inside the second virtual cone, of virtual light assumed to have been projected from the center point is projected from the top face to outside, a component, existing outside the second virtual cone but inside the first virtual cone, of the virtual light assumed to have been projected from the center point is totally reflected at the top face and projected to outside from the lateral face, and a component, existing outside the first virtual cone, of the virtual light assumed to have been projected from the center point is projected from the lateral face to outside.

In the above first-, second- and third-mode embodiments of the present invention (will also be referred to simply as "present invention" wherever appropriate hereunder), on the assumption that the function representing the top and lateral faces is defined by an assumed cylindrical coordinate $(r, \phi, z)$ of which the origin is the center point (center of the bottom face), the value of the z-coordinate of the top face is positive, that of the upper end of the lateral face is positive value and that of the lower end of the lateral face is positive, zero (0) or negative. It should be noted that in case the function representing the top and lateral faces is defined by a Gaussian coordinate $(x, y, z)$, it will be $r^2 = x^2 + y^2$.

Also in the above third-mode embodiment of the present invention, the phrase "virtual light assumed to have been projected from the center point" referred to herein is used for the following reason. The actual light-emitting element has a finite size. For example, the light path of light projected from one end of the light-emitting element is subtly different from that of light projected from the other end. Accordingly, to explain the lens and that included in the light-emitting element assembly, surface light source device or in the color liquid crystal display assembly, it is assumed that light is projected from a virtual point source positioned at the center point, which leads to the phrase "virtual light assumed to have been projected from the center point".

In the above first- and second-mode embodiments of the present invention, a function $r = f_T(r)$ where r is a variable representing the top face being an aspheric surface may be a hyperboloid given by the following expression (1):

$$Z = \frac{cr^2}{1 + \sqrt{1 - c^2 r^2 \left(1 - e^2\right)}} + a$$

$$\ldots\ldots\ldots \quad (1)$$

where "c" is a curvature (vertex curvature) at the vertex where the hyperboloid intersects with the z-axis, "e" is an eccentricity and the zero-order coefficient "a" is given by an expression "a = [c(e$^2$ - 1)]$^{-1}$ + p" where "p" should preferably satisfy a requirement "-a < p ≤ a·e", for example, "-0.7a < p ≤ a·e", and more preferably satisfy a requirement "p = 0".

Note here that a quadric surface may generally be given by the expression (1) of the cylindrical coordinate system (r, $\phi$, z). The "-e$^2$" in the expression (1) is also called "Kornich constant (K)" or "conic constant". Generally, when K = 0, the expression (1) defines a spherical surface, when K = -1, the expression (1) defines a paraboloid, when K < -1, the expression (1) defines a hyperboloid, and when -1 < K < 0, the expression (1) defines an ellipsoid.

In the above first- or second-mode embodiment of the present invention, the eccentricity "e" should preferably satisfy a requirement "1.40 ≤ e ≤ 1.58" in the above case, and "c" should preferably satisfy a requirement given by the following expression (2):

$$\frac{e^2 - 1}{1 + 2\sqrt{e^2 - 1}\frac{z_1}{d}} z_1 \le \frac{1}{c} \le \frac{e^2 - 1}{e} z_1$$

$$\ldots\ldots\ldots \quad (2)$$

where "d" which is a size of the surface light source is given by $S_{LS} = \pi(d/2)^2$
where $S_{LS}$ is the area of a portion of the surface light source from which light is actually emitted.

It should be noted that the expression (2) is derived as will be described later.

In the first-mode embodiments of the present invention including those in the above various preferred modes, the function r = $f_s$(z) where z is a variable representing the lateral face being an aspheric surface may be defined by a polynomial of nth- or higher order (quartic or higher, for example). It should be noted that for the function to have at least one point where the absolute value $|d^2 r/dz^2|$ of the second-order differential coefficient of the variable z takes a maximum value in the closed zone, there should exist a point where a third-order differential coefficient $d^3 r/dz^3$ of the variable z in the closed zone is zero (0). Therefore, the function r = $f_s$(z) should preferably be defined by a fourth- or higher order polynomial.

Moreover, in the first- or second-mode embodiments of the present invention including those in the above various preferred modes, the refractive index $n_1$ of the material of the lens should preferably be 1.48 ≤ $n_1$ ≤ 2.5, and more preferably be 1.6 ≤ $n_1$ ≤ 1.8.

In the above third-mode embodiment of the present invention including those in the above various preferred modes, when the refractive index of the material of the lens is $n_1$ and that of the outer medium is no, a cone generating angle formed between the second virtual cone and a virtual plane cutting the second virtual cone and including the axis (will expediently be referred to as "z-axis" wherever appropriate hereunder) is $\theta_2$ and an angle formed between the lens and a virtual plane cutting the lens and including the axis (z-axis) and at which the line normal to the top face, passing through a point where the second virtual cone and top face intersect with each other is $\theta_0$, the cone angle (solid angle) $\Omega_2$ (= $2\pi$ [1-cos($\theta_2$)]) will satisfy a requirement "sin ($\theta_2 + \theta_0$) = ($n_0/n_1$)". In this case, the refractive index $n_0$ should preferably be $n_0$ = 1.00, 1.48 ≤ $n_1$ ≤ 2.5, and more preferably be 1.6 ≤ $n_1$ ≤ 1.8.

Also in the above third-mode embodiment of the present invention including those in the above preferred modes, an amount $LF_T$ of a light component assumed to have been projected from the center point to outside through a top-face portion from which the emitted light is projected (luminous-flux amount of the light component assumed to have been projected from the center point to outside through the top face) and amount $LF_S$ of a light component assumed to have been projected from the center point to outside through the lateral face (luminous-flux amount of the other light component assumed to have finally been projected to outside through the lateral face) should preferably satisfy a requirement "0 ≤ $LF_S/(LF_S + LF_T)$ ≤ 0.84", and more desirably satisfy a requirement "0 ≤ $LF_S/(LF_S + LF_T)$ ≤ 0.90".

Also in the above third-mode embodiment of the present invention including those in the above preferred modes, the top face may be formed from a hyperboloid of revolution. In this case, the hyperboloid of revolution may be given by the aforementioned expression (1), for example. It should be noted that the center point may be positioned within a range defined by a midpoint between two focuses of the hyperboloid of revolution and focus, at the convex side, of the hyperboloid of revolution inside the two focuses (will expediently be referred to as "the one focus" wherever appropriate hereunder) for the following reason. With this geometry in which the center point is positioned nearer than the one focus of the hyperboloid of revolution as above, a virtual image of light-emitting element disposed near the center point will be added to the light emitted from the light-emitting element, resulting in improvement of the luminous efficiency of the entire light-emitting element assembly. The other one of the focuses is positioned on the z-axis on the opposite side across the hyperboloid of revolution. Since the light-emitting element has a finite size, it cannot be positioned "precisely" at the one focus of the hyperboloid of revolution.

It should be noted however that in the above third-mode embodiment of the present invention, the rotational symmetric curved surface defining the top face and convexed toward the bottom face is not limited to the hyperboloid of revolution. More specifically, the rotational symmetric curved surface forming the top face and convexed toward the bottom face as in the third-mode embodiment of the present invention and the aspheric surface forming the top face as in the first- and second-mode embodiments of the present invention ("rotational symmetric curved surface forming the top face and convexed toward the bottom face" or as "aspheric surface forming the top face" will generically be referred to simply as "curved surface forming the top face" wherever appropriate hereunder) may be defined by an aspheric function in which the zero-order coefficient "a" at the right side of the aforementioned expression (1) is replaced with "A $\times$ r$^4$+ B $\times$ r$^6$ + C $\times$ r$^8$+ ...", spherical surface, ellipsoid or paraboloid of revolution. Otherwise, the rotational symmetric curved surface and aspheric surface may be a curved surface obtainable by rotating a part of a curve such as a polynomial of third- or higher order, two-sheet line, three-sheet line, four-sheet line, lemniscate, cochlea line, regular folium, conchoid, cissoid, likelihood curve, tractrix, suspended line, cycloid, trochoid, asteroid, half-tertiary paraboloid, Bowditch curve, witch of Agnesi, epicycloid, cardioid, hypocycloid, clothoid curve, helix, etc. Also, the surface whose section along a virtual plane including the axis (z-axis) is an aggregate of successive line segments is included in a "curved surface forming the top face". That is, the "curved surface forming the top face" includes a smooth curved surface as well as a non-smooth curved surface (curved surface having a singularity that cannot be differentiated). Also, the "curved surface forming the top face" may be an assembly of such smooth and non-smooth curved surfaces. That is, according to the third-mode embodiment of the present invention, for example, a top-face portion (will be referred to as "first top-face portion" hereunder) being nearer to the z-axis side than the top-face portion to which the first virtual cone is tangent and top-face portion (will be referred to as "second top-face portion" hereunder) in a position outer than the first top-face portion, the curved surface forming the first top-face portion and that forming the second top-face portion may be made different from each other. Further, the second top-face portion may be planar, for example. Also, according to the first- or second-mode embodiment of the present invention, in the curved surface forming the "total-reflecting portion of the top face" (first top-face portion) and top-face portion in a position outer than a "total-reflecting portion of the top face" (second top-face portion), the curved surface forming the "total-reflecting portion of the top face" (first top-face portion) and that forming the second top-face portion may be made different from each other. Moreover, the second top-face portion may be planar, for example.

Note that a revolution-hyperboloid convex mirror is used in, a Cassegrain telescope, for example as described in the "Lens Design Fundamentals" (by Rudolf Kingslake, Academic Press, 1978, pp. 304). However, the revolution-hyperboloid convex mirror is intended to form an image, not to lead out light from the surface light source as in the first- to third-mode embodiments of the present invention. Also, the revolution-hyperboloid convex mirror used in the Cassegrain telescope is coated with a metallic film or the like, and the total reflection by the mirror is utilized as in the first- to third-mode embodiments of the present invention. It should be noted that the aforementioned expression (1) is explained in detail in the page 303 and subsequent pages of the "Lens Design Fundamentals".

Also in the second-mode embodiments of the present invention including those in the above preferred modes, the bottom face should preferably be centered nearly at the focal distance of the lateral face that effectively functions as a convex lens. Also, in the third-mode embodiments of the present invention including those in the above preferred modes, the lateral face effectively functions as a convex lens, and the bottom face should preferably be centered nearly at the focal distance of the lateral face effective as the convex lens. In these cases, the aspheric surface or rotational symmetric curved surface forming the lateral surface may be a toric surface (toroidal surface) given by " r = $f_S(z)$ + $k_0$' = $k_n \cdot z^n$ + $k_{(n-1)} \cdot z^{(n-1)}$ + $k_{(n-2)} \cdot z^{(n-2)}$ + ... + $k_1 \cdot z$ + $k_0$ + $k'_0$" in the cylindrical coordinate system of an nth-order polynomial (x, $\phi$, z). The value (in degrees) of a polar angle $\Theta_1$ of a point of the lateral face that shows a highest effect as a convex lens may be given by "$75° \leq \Theta_1 < 87°$". Further, the absolute value of a second-order differential coefficient of the nth-order polynomial defining a rotational symmetric curved surface forming the lateral face within a range of the lateral face should preferably have at least one maximum.

However, the curved surface forming the lateral face in the first- and second-mode embodiments of the present invention and rotational symmetric curved surface forming the lateral face and convexed toward the lateral face in the third-mode embodiment of the present invention (the curved surface forming the lateral face or rotational symmetric curved surface convexed outwardly will generically be referred to simply as "curved surface forming the lateral face" wherever appropriate hereunder) may not be limited to any nth-order polynomial but may be a spherical surface, ellipsoid or paraboloid of revolution. Otherwise, the "curved surface forming the lateral face" may be a curved surface obtainable by rotating a part of a curve such as two-sheet line, three-sheet line, four-sheet line, lemniscate, cochlea line, regular folium, conchoid, cissoid, likelihood curve, tractrix, suspended line, cycloid, trochoid, asteroid, half-tertiary paraboloid, Bowditch curve, witch of Agnesi, epicycloid, cardioid, hypocycloid, clothoid curve, helix, etc. Also, the surface whose section along a virtual plane including the axis (z-axis) is an aggregate of successive line segments is included in a "curved surface forming the lateral face". That is, the "curved surface forming the lateral face" includes a smooth curved surface as well as a non-smooth curved surface (curved surface having a singularity that cannot be differentiated). Also, the "curved surface forming the lateral face" may be an assembly of such smooth and non-smooth curved surfaces. That is, according to the third-mode embodiment of the present invention, for example, a component, existing outside the second virtual cone but inside the first virtual cone, of the virtual light assumed to have bee projected from the center point is totally reflected at the top face and projected to outside from the lateral face. However, when this lateral-face portion is taken as a first lateral-face portion, a component, positioned outside the first virtual cone, of the virtual light assumed to have bee projected from the center point is projected from the lateral face to outside. In case the above lateral-face portion is taken as a second lateral-face portion, the first and second lateral-face portions may be formed from different curved surfaces, respectively. Further, the present invention is not limited to the above example but the first and second lateral-face portions may be formed from a plurality of curved surfaces to subdivide the light-refracting areas into a (1-1)th lateral-face portion, (1-2)th lateral-face portion, ... , and a (2-1)th lateral-face portion, (2-2)th lateral-face portion, ..., respectively. This is also true for the curved surface forming the lateral face in the first- or second-mode embodiment of the present invention.

Also in the first- second-mode embodiments of the present invention including those in the above preferred modes, a reflecting layer may be formed over the outer surface of at least the "top-face portion from which the emitted light is projected". Also, in the third-mode embodiment of the present invention, such a reflecting layer may be formed on the outer surface of a top-face portion included in at least the second virtual cone. Thus, in the third-mode embodiment of the present invention, for example, a component, existing inside the second virtual cone, of the light assumed to have been projected from the center point is reflected at the reflecting layer, not being projected from the top face to outside. The light reflected by the top face is projected from the lateral or bottom face. This is also true for the first- and second-mode embodiments of the present invention. In case the reflecting layer is of a structure including a plurality of dielectric layers, it may be formed only on the outer surface of the "top-face portion from which the emitted light is projected" or on the outer surface of a top-face portion included in the second virtual cone. Otherwise, it may be formed on the outer surface of the entire top face. In this case, the light will totally be reflected at the top face. The reflecting layer may be formed from a stack of an $SiO_2$ layer and $TiO_2$ layers, for example. On the other hand, in case the reflecting layer is formed from a metal layer (including an alloy layer), it should be formed only on the outer surface of the "top-face portion from which the emitted light is projected" or top-face portion included in the second virtual cone.

In the light-emitting element assemblies embodied in the first- to third modes of the present invention, surface light source devices embodied in the first to third modes of the present invention or color liquid crystal display assemblies embodied in the first to third modes of the present invention, the light-emitting element may be a light-emitting diode (LED) including a substrate and a light-emitting layer formed on the substrate. A part of the bottom face of the lens may be designed to be in contact with the light-emitting layer included in the light-emitting diode with a light-transparent medium layer being laid between them (face-up structure). Otherwise, the light-emitting element may be a light-emitting diode (LED) so formed from a substrate and a light-emitting layer formed on the substrate that light emitted from the light-emitting layer will pass through the substrate and be projected to outside, and the part of the bottom face of the lens may be designed to be in contact with the light-emitting layer included in the light-emitting diode with a light-transparent medium layer being laid between them (flip-chip structure). It should be noted regarding the latter case that for easier and more accurate positioning of the lens and light-emitting diode, a projection and/or concavity should preferably be formed in a portion of the substrate, which is to be in contact with the bottom face of the lens, and a concavity and/or projection, mating with the projection and/or concavity, respectively, should preferably be formed in a portion of the bottom face of the lens, which is to be in contact with the substrate. It should also be noted that the radius of curvature of the projection should desirably be larger than that of the concavity

The light-transparent medium layer may be of an epoxy resin (1.5 in refractive index, for example) transparent to light emitted from the light-emitting element, gel-state material (OCK-451 by Nye (1.51 in refractive index) or OCK-433 by Nye (1.46 in refractive index), for example) or an oil compound such as silicon rubber, silicon oil compound (TSK5353 by Toshiba Silicon (1.45 in refractive index), for example). It should be noted that the light-transparent medium layer may light-emitting particles mixed therein. Mixing of such light-emitting particles in the light-transparent medium layer permits to widen the range of choice of the light-emitting element (range of choice of emission wavelength).

The light-emitting particles may include red phosphor particles, green phosphor particles and blue phosphor particles. The red phosphor particles may be of any one selected from among $Y_2O_3$:Eu, $YVO_4$:Eu, $Y(P, V) O_4$:Eu, $3.5MgO \cdot 0.5MgF_2 \cdot Ge_2$:Mn, $CaSiO_3$:Pb, Mn, $Mg_6AsO_{11}$:Mn, $(Sr, Mg)_3 (PO_4)_3$:Sn, $La_2O_2S$:Eu, $Y_2O_2S$:Eu, (ME:Eu)S ("ME" means at least one kind of atom selected from a group of Ca, Sr and Ba; this is also true for the following explanation),

(M:Sm)$_x$ (Si, Al)$_{12}$ (O, N)$_{16}$ ("M" means at least one kind of atom selected from a group of Li, Mg and Ca; this is also true for the following explanation), ME$_2$Si$_5$N$_8$:Eu, (Ca:Eu) SiN$_2$ and (Ca:Eu)AlSiN$_3$. Also, the green phosphor particles may be of any one selected from among LaPO$_4$:Ce, Tb, BaMgAl$_{10}$O$_{17}$:Eu, Mn, Zn$_2$SiO$_4$:Mn, MgAl$_{11}$O$_{19}$:Ce, Tb, Y$_2$SiO$_5$: Ce, Tb, MgAl$_{11}$O$_{19}$:CE, Tb, Mn, (ME:Eu)Ga$_2$S$_4$ and (M:RE)$_x$ (Si, Al)$_{12}$ (O, N)$_{16}$ ("RE" means Tb and Yb), (M:Tb)$_x$ (Si, Al)$_{12}$ (O, N)$_{16}$ and (M:Yb)$_x$ (Si, Al)$_{12}$ (O, N)$_{16}$. Also, the blue phosphor particles may be of any one selected from among BaMgAl$_{10}$O$_{17}$:Eu, BaMg$_2$Al$_{16}$O$_{27}$:Eu, Sr$_2$P$_2$O$_7$:Eu, Sr$_5$ (PO$_4$)$_3$Cl:Eu, (Sr, Ca, Ba, Mg)$_5$(PO$_4$)$_3$C1:Eu, CaWO$_4$ and CaWO$_4$: Pb.

However, the light-emitting particles are not limited to the above phosphor particles but may be of, for example, an indirect transition type silicon material having a quantum well structure such as a two-dimensional quantum well structure, one-dimensional quantum well structure (quantum thin line), zero-dimensional quantum well structure (quantum dot) or the like in which the carrier wave function is localized for efficient conversion of the carrier into light as in the direct transition type silicon material.

The light-emitting diode (LED) is of a laminated structure including a first clad layer formed from a first conductive type (n-type, for example) compound semiconductor layer formed on the substrate, an active layer formed on the first clad layer and a second clad layer formed from a second conductive type (p-type, for example) compound semiconductor layer formed on the active layer, for example, and has a first electrode electrically connected to the first clad layer and a second electrode electrically connected to the second clad layer. The layer forming the light-emitting diode may be formed from a well-known compound semiconductor material depending upon the emission wavelength, and the substrate may be formed from a well-known material such as sapphire (1.785 in refractive index), GaN (2.438 in refractive index), GaAs (3.4 in refractive index), AlInP (2.86 in refractive index), alumina (1.78 in refractive index) or the like.

The lens may be formed from a material for the glass lens. The material may be a plastic material having a high refractive index such as PRESTAGE (by Seiko Optical Products; 1.74 in refractive index), ULTIMAX V AS 1.74 (by Showa Kogaku; 1.74 in refractive index) or NL5-AS (by Nikon Echelol; 1.74 in refractive index). Also, the material may be selected from among a glass material such as NBFD11 (refractive index $n_1$ = 1.78), optical glass such as M-NBFD82 (refractive index $n_1$ = 1.81) or M-LAF81 (refractive index $n_1$ = 1.731) available from HOYA, an inorganic dielectric material such as KTiOPO$_4$ (refractive index $n_1$ = 1.78), and lithium niobate (LiNbO$_3$) (refractive index $n_1$ = 2.23).

The surface light source device has disposed in a housing thereof a plurality of red light-emitting element assemblies to emit red light (of 640 nm in wavelength, for example), a plurality of green light-emitting element assemblies to emit green light (of 530 nm in wavelength, for example) and a plurality of blue light-emitting element assemblies to emit blue light (of 450 nm in wavelength, for example). The light-emitting element assemblies are disposed as follows. For example, a red light-emitting element assembly, green light-emitting assembly and a blue light-emitting assembly are grouped in one set. A plurality of such sets is successively laid horizontally in the plane of the color liquid crystal display assembly to form an array of light-emitting element assemblies. A plurality of such light-emitting element assembly arrays is disposed vertically of the screen of the color liquid crystal display assembly. It should be noted that the light-emitting element assemblies may be set in any one selected from a plurality of combinations including a combination of one red light-emitting element assembly, one green light-emitting element assembly and one blue light-emitting element assembly, a combination of one red light-emitting element assembly, two green light-emitting element assemblies and one blue light-emitting element assembly, a combination of two red light-emitting element assemblies, two green light-emitting element assemblies and one blue light-emitting element assembly, and the like. Further, the surface light source device may include an optical-functional group including a diffusion plate, diffusion sheet, prism sheet and a polarization sheet, and a reflecting sheet. It should be noted that the surface light source device may further include a light-emitting element assembly that emit light of a fourth color other than the red, green and blue as the three primary colors.

Generally, the color density of the light-emitting diode depends upon the operating current. Therefore, for high-fidelity reproduction of a color while obtaining a desired brightness, namely, to maintain a constant color temperature, the light-emitting diode should preferably be driven by a pulse width modulation (PWM) signal. Changing the duty ratio of the pulse width modulation (PWM) signal will provide a linear change in mean forward current and brightness of the light-emitting diode.

The transparent or semitransparent type color liquid crystal display includes, for example, a front panel having a transparent first electrode, rear panel having a transparent second electrode and a liquid crystal material disposed between the front and rear panels.

The front panel includes, for example, a first substrate formed from glass or silicon, a transparent first electrode (also called "common electrode"; it is formed from ITO, for example) provided on the inner surface of the first substrate, and a polarization film provided on the outer surface of the first substrate. Further, the front panel has provided on the inner surface of the first substrate thereof a color filter coated with an overcoat layer of acrylic resin or epoxy resin. Namely, the transparent first electrode is formed on the overcoat layer. An aligned film is provided on the transparent first electrode. The color filter may be disposed in a delta, stripe, diagonal or rectangle pattern. On the other hand, the rear panel includes, for example, a second substrate formed from glass or silicon, a switching element formed on the inner surface of the second substrate, a transparent second electrode (also called "pixel electrode"; it is formed from ITO, for example) of which the on/off state is controlled by the switching element, and a polarization film provided on the outer surface of the second substrate. An aligned film is formed over the rear panel including the transparent second electrode. Various members and liquid material of the transparent or semitransparent type color liquid crystal display may be well-known ones. It should be noted that the switching element may be a three-terminal element such as a MOS FET formed on a monocrystal silicon semiconductor substrate or a thin film transistor formed on a glass substrate or a two-terminal element such as MIM element, varistor element, diode or the like.

The surface light source device according to the present invention is suitably usable not only in the color liquid crystal display assembly but as lights and lamps provided on carriers including car, electric car, ship, aircraft and the like, such as headlight, taillight, high-mount stop light, small light, turn signal lamp, fog light, interior light, instrument panel lights, light sources incorporated in various buttons, destination indicator, emergency light, emergency exit guide light and the like, lights and lamps provided in a building, such as an outdoor light, interior light, panel light, emergency light, emergency exit guide light and the like, street light, signal light, indicator lights and lamps used on an advertising display, machine, equipment, etc., panel lights and light let-in units in a tunnel, underground passage, etc.

In the first- or second-mode embodiment of the present invention, the lens is formed from only the circular bottom face, lateral face formed from an aspheric surface and top face formed from an aspheric surface. In the third-mode embodiment of the present invention, the lens is formed from by the circular bottom face, lateral face formed from the rotational symmetric curved surface convexed outwardly and rotational symmetric top face convexed toward the bottom face. It is simple in shape and can be produced massively with a high productivity. Also, it can be produced with an extremely low possibility of variation in shape and very freely from defect (cracking). Also, a substantial proportion of light emitted from the surface light source and incident upon the top face is totally reflected by the top face and projected to outside from the lateral face, and a substantial proportion of the light emitted from the surface light source and incident directly upon the lateral face is projected from the lateral face to outside. So, the luminous-flux amount of the light component emitted from the surface light source and projected from the lateral face to outside via the direct and indirect light paths can be increased in relation to the total luminous-flux amount. Also, since the component, existing outside the second virtual cone but inside the first virtual cone, of the virtual light assumed to have been projected from the center point is totally reflected by the top face while the component, existing outside the first virtual cone, of the virtual light assumed to have been projected from the center point is projected from the lateral face to outside, the luminous-flux amount of the light assumed to have been projected from the center point to outside through the lateral face can be increased in relation to the total luminous-flux amount. Thus, it is possible to implement a two-dimensional projection system (in-plane projection system) by which the light is projected mainly horizontally of the lens with a high efficiency. Therefore, it is possible to provide a high-brightness semiconductor light-emitting element light source suitable for use as the backlight of a liquid crystal display.

The foregoing and other features, aspects and advantages of the present invention will become apparent from the following detailed description of embodiments of the present invention when taken in conjunction with the accompanying drawings.

Brief Description of the Drawings

FIG. 1 is a schematic perspective view of a lens according to Embodiment 1.
FIG. 2 is a conceptual diagram for explaining the lens according to Embodiment 1.
FIG. 3 is a schematic sectional view of the lens according to Embodiment 1.
FIGS. 4A and 4B are schematic sectional views, respectively, of a light-emitting diode.
FIGS. 5A and 5B are conceptual diagrams, respectively, of a light-emitting element assembly according to Embodiment 1.
FIGS. 6A and 6B are schematic sectional views, respectively, of the completed light-emitting element assembly according to Embodiment 1 and light-emitting diode, respectively.
FIG. 7A schematically illustrates the disposition of the light-emitting element assemblies in the surface light source device according to Embodiment 1, and FIG. 7B is a schematic fragmentary sectional view of the surface light source device and color liquid crystal display assembly according to Embodiment 1.
FIG. 8 is a schematic fragmentary sectional view of the color liquid crystal display assembly according to Embodiment 1.
FIG. 9A illustrates the visible outlines, taken along an x-z plane, of the lateral and top faces of the lens according to Embodiment 1, and FIG. 9B graphically illustrates a reciprocal ($1/|d^2r/dz^2|$) of the absolute value of second-order differential coefficient of nth-order polynomial defining the rotational symmetric curved surface forming the lens according to Embodiment 1.

FIG. 10 graphically illustrates results of plotting of a radius of curvature $c^{-1}$ satisfying the conditional expression (2) or (9) with the eccentricity e being taken as an independent variable when $z_{max}$ = 1.842 mm and d = 1.0 mm.
FIG. 11 schematically illustrates a light component projected from the lateral face of the lens.
FIG. 12 schematically illustrates light components projected from the spherical and aspheric surfaces.
FIG. 13 graphically illustrates results of calculation of the distribution of angles at which the emitted light component is projected from the lateral face of the lens according to Embodiment 1 in case the lateral face is given by an expression (3) having the value shown in Table 1.
FIG. 14 shows results of calculation of a light-ray tracking in the x-z plane when the refractive index $n_1$ of the material of the lens is 1.74.
FIG. 15 shows results of simulation of how light emitted from a point source is projected from the top and lateral faces, made on the assumption that the point source is disposed at the center point of the lens according to Embodiment 1.
FIG. 16 graphically illustrates results of determination of an intersection between the top and lateral faces in the x-z plane with the value of "a" being fixed at 0.6 and eccentricity e being taken as a parameter.
FIGS. 17A and 17B graphically illustrate results of calculation of an angle ω at which the light is led out when the eccentricity e and value of "a" in the expression (1) defining the top face are varied.
FIG. 18 shows light paths along which marginal light components projected from one end (-0.5, φ, 0) and other end (0.5, φ, 0), respectively, of the surface light source on the assumption that (a, e) = (0.7; 1.48).
FIG. 19 graphically illustrates results of calculation, made on the assumption that (a, e) = (0.7, 1.48), of a lead-out angle ω for the marginal light components projected from one end (-0.5, φ, 0) and other end (0.5, φ, 0), respectively, of the surface light source, a lead-out angle ω for the marginal light components projected from one end (-0.6, φ, 0) and other end (0.6, φ, 0), respectively, of the surface light source, and a lead-out angle ω for the marginal light components projected from one end (-0.7, φ, 0) and other end (0.7, φ, 0), respectively, of th surface light source.
FIG. 20 graphically illustrates plotting of a performance function ET being "(α + β)ω" with the size of the surface light source being taken as a variable.
FIG. 21 graphically illustrates results of calculation, made on the assumption that the surface light source is 1.2 mm in size, of change in ET value when the surface light source is moved -0.1 mm and 0.1 mm, respectively, in relation to the lens in an observing direction (x direction) from a state in which the axis of the lens coincides with that of the surface light source.
FIG. 22 graphically illustrates results of determination of the allowable shift of surface light sources different in size from each other.
FIG. 23 graphically illustrates the visible outlines, taken along an x-z plane, of the lateral and top faces of the lens according to Embodiment 2.
FIG. 24A graphically illustrates results of calculation of the total luminous-flux amount from the lens according to Embodiment 2 in which "α" is taken as a parameter, made on the assumption that the size of the light-emitting surface of the light-emitting diode is 1.0 mm x 1.0 mm, and FIG 24B graphically illustrates of calculation of a far-field program (FFP).
FIG. 25 shows results of simulation of how light emitted from a point source assumed to be disposed at the center point of the lens in which "α" (= 0.5) is taken as a parameter is projected from the top and lateral faces of the lens according to Embodiment 2.
FIGS. 26A and 26B are schematic sectional views, respectively, of a variant of the lens.
FIG. 27 shows a flow of operations made in the procedure for production of the light-emitting element assembly according to Embodiment 1.
FIG. 28A is a schematic sectional view of a lens disclosed in the Nikkei Electronics, page 128, Dec. 20, 2004, and FIG. 28B is a conceptual diagram of a conventional direct-underlying type surface light source device.
FIG 29 graphically illustrates a hyperboloid given by the aforementioned expression (1).
FIGS. 30A and 30B explain the cylindrical coordinate (r, φ, z) and polar coordinate (r, Θ, φ).

Best Mode for Carrying Out the Invention

The present invention will be explained in detail below concerning the embodiments thereof with reference to the accompanying drawings.

Embodiment 1:

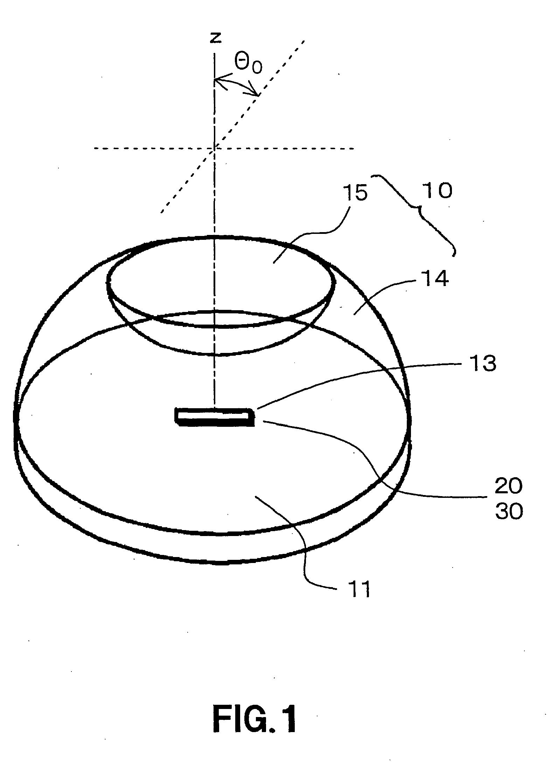

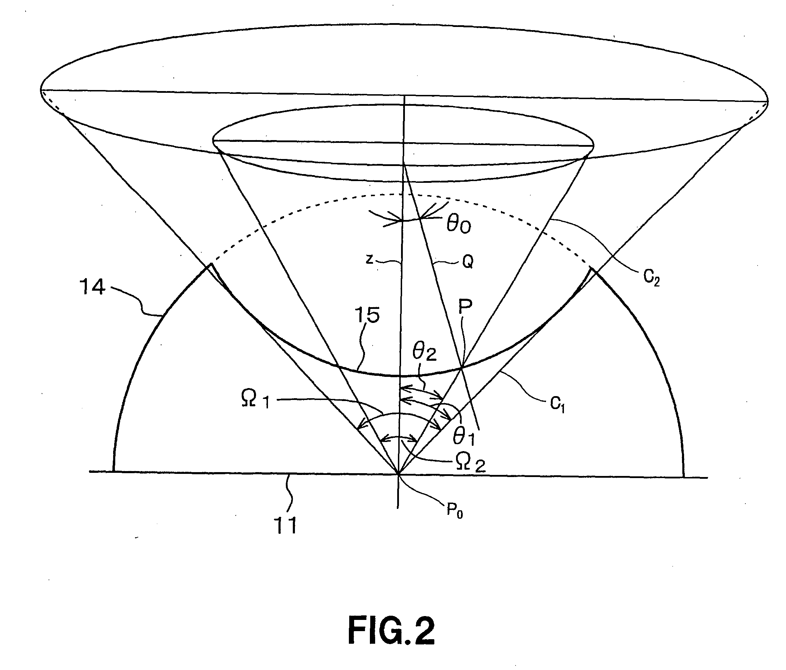

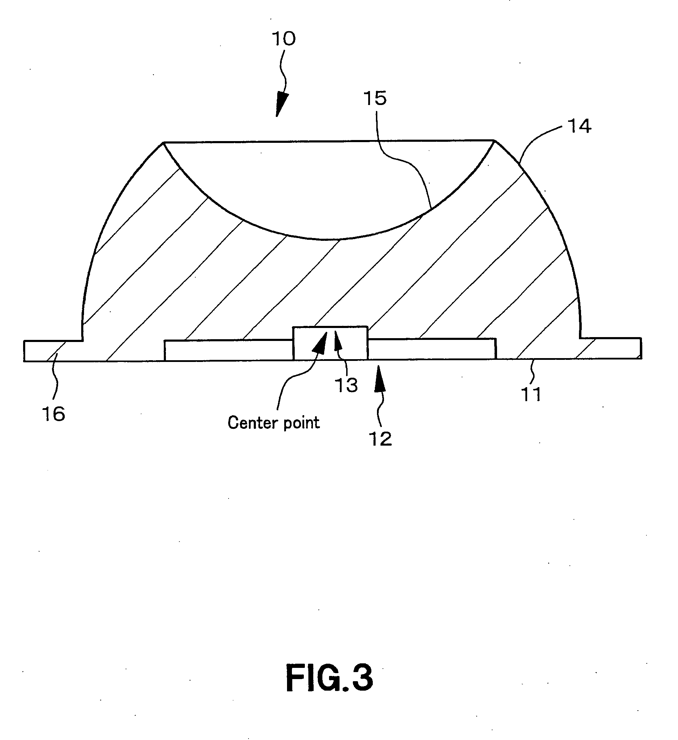

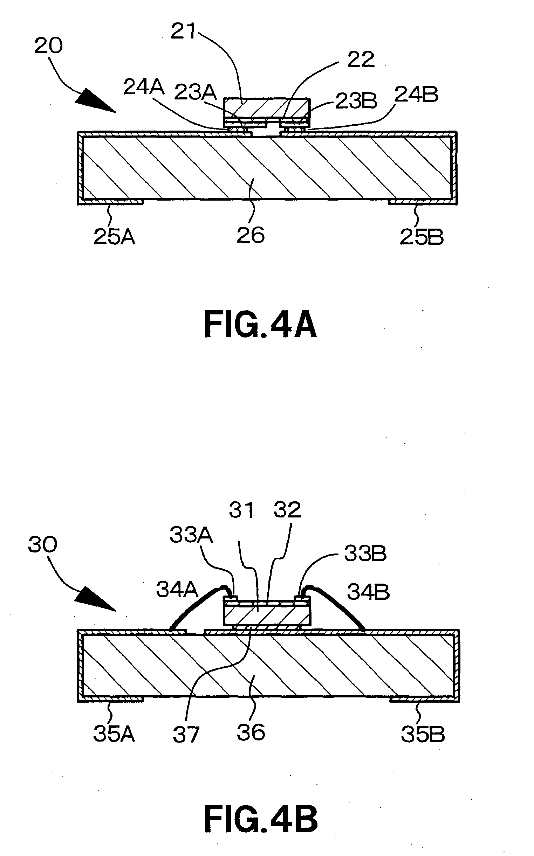

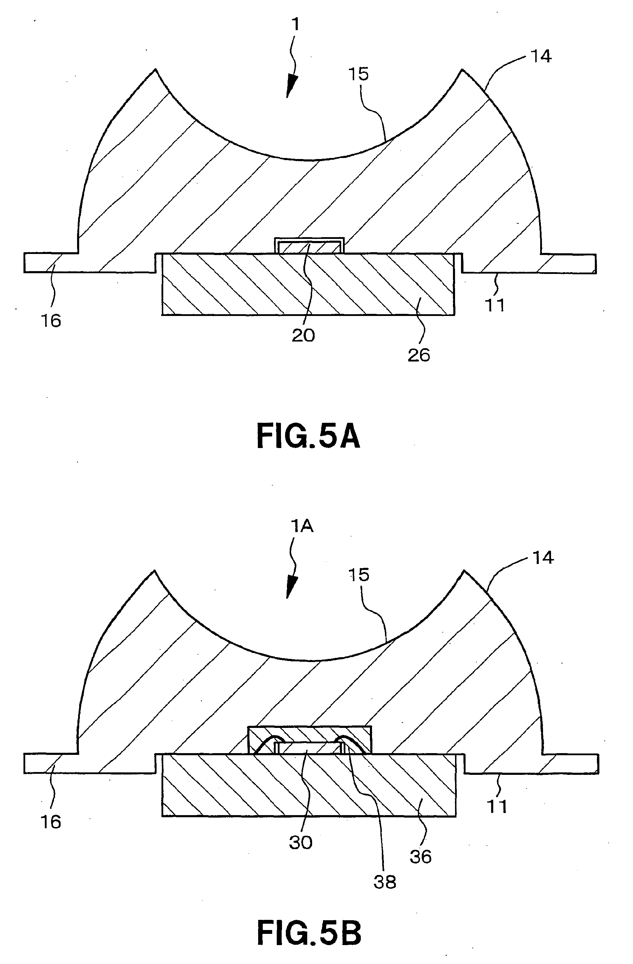

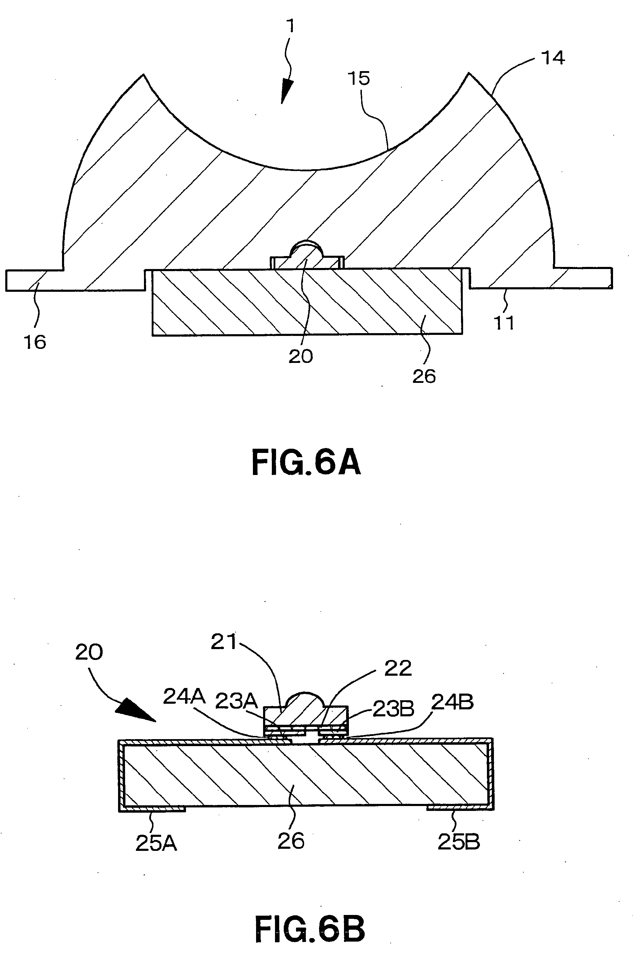

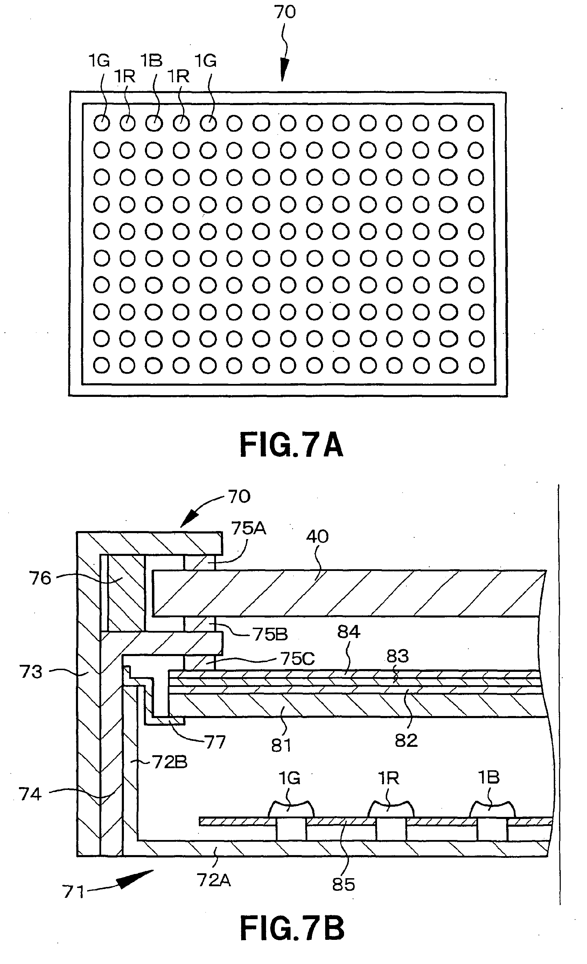

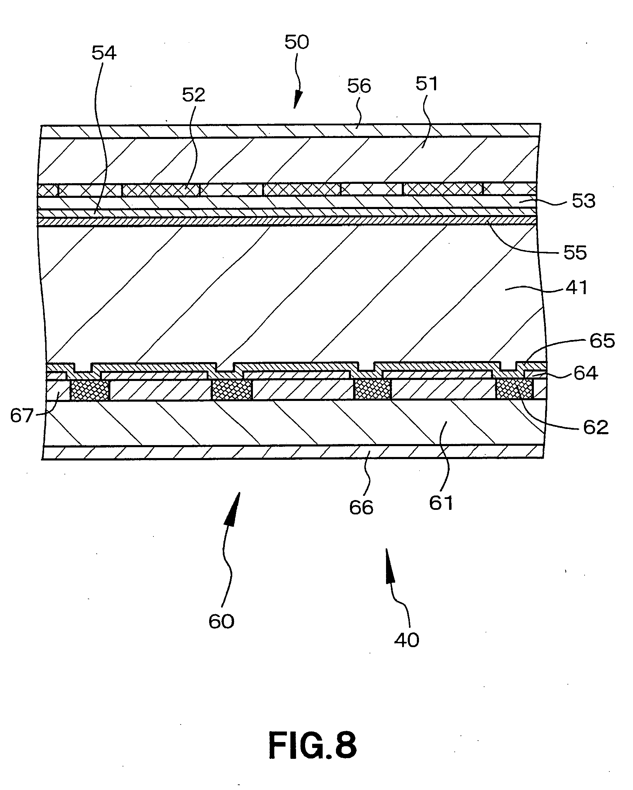

The Embodiment 1 includes the lenses embodied in the first to third modes of the present invention, light-emitting element assemblies embodied in the first to third modes of the present invention, surface light source devices embodied in the first to third modes of the present invention and color liquid crystal display assemblies embodied in the first to third modes of the present invention. It should be noted that an "apparatus" embodied in any of the first to third modes of the present invention will be referred to as an "apparatus according to Embodiment 1" hereunder. FIG. 1 is a schematic perspective view of the lens according to Embodiment 1, FIG. 2 is a conceptual diagram for explaining the lens according to Embodiment 1, FIG 3 is a schematic sectional view of the lens according to Embodiment 1, FIGS. 4A, 4B and 6B are schematic sectional views, respectively, of a light-emitting diode, FIGS. 5A, 5B and 6A are conceptual diagrams, respectively, of a light-emitting element assembly according to Embodiment 1, FIG. 7A schematically illustrates the disposition of the light-emitting element assemblies in the surface light source device according to Embodiment 1, and FIG 7B is a schematic fragmentary sectional view of the surface light source device and color liquid crystal display assembly according to Embodiment 1, and FIG. 8 is a schematic fragmentary sectional view of the color liquid crystal display assembly according to Embodiment 1.

Embodiment 1 will first be explained based on the first and second modes in which the present invention was carried out, and then based on the third mode. It should be noted that according to Embodiment 1, for example, the glass material M-LAF81 (by Hoya; refractive index $n_1$ = 1.731) was used to make a lens 10. The external medium is air of which the refractive index $n_0$ is 1.00.

A light-emitting element assembly 1 (1A) according to Embodiment 1 in the first and second modes of the present invention includes the lens 10 and a light-emitting diode 20 (30) as a surface light source having a finite size. The lens 10 is formed from a circular bottom face 11, lateral face 14 and top face 15, and has the light-emitting element 20 (30) disposed as a surface light source at the center of the bottom face 11 thereof. Also, the light-emitting element assembly 1 (1A) according to Embodiment 1 has the light-emitting diode 20 (30) disposed at the center of the bottom face 11. Further, a surface light source device 70 that backlights a transparent type color liquid crystal display 40 includes a plurality of red light-emitting element assemblies 1R, a plurality of green light-emitting element assemblies 1 G and a plurality of blue light-emitting element assemblies 1B. The color liquid crystal display assembly includes the transparent type color liquid crystal display 40 and surface light source device 70 which backlights the color liquid crystal display 40.

Here is assumed for the lens a cylindrical coordinate (r, φ, z) of which the origin is the center of the bottom face and z-axis is a normal line Q passing through the center of the bottom face 11. It should be noted that the cylindrical coordinate can be given as follows by a Gaussian coordinate (x, y, x):

$$r^2 = x^2 + y^2$$

$$x = r{\cdot}\cos(\phi)$$

$$y = r{\cdot}\sin(\phi)$$

$$\tan(\phi) = y/x$$

Also, the cylindrical coordinate can be given as following by a polar coordinate (r, Θ,

$$r^2 = x^2 + y^2 + z^2$$

$$x = r{\cdot}\cos(\phi){\cdot}\sin(\Theta)$$

$$y = r{\cdot}\sin(\phi){\cdot}\sin(\Theta)$$

$$z = r \cdot \cos(\Theta)$$

$$\tan(\Theta) = (x^2 + y^2)^{1/2}/z$$

$$\tan(\phi) = y/x$$

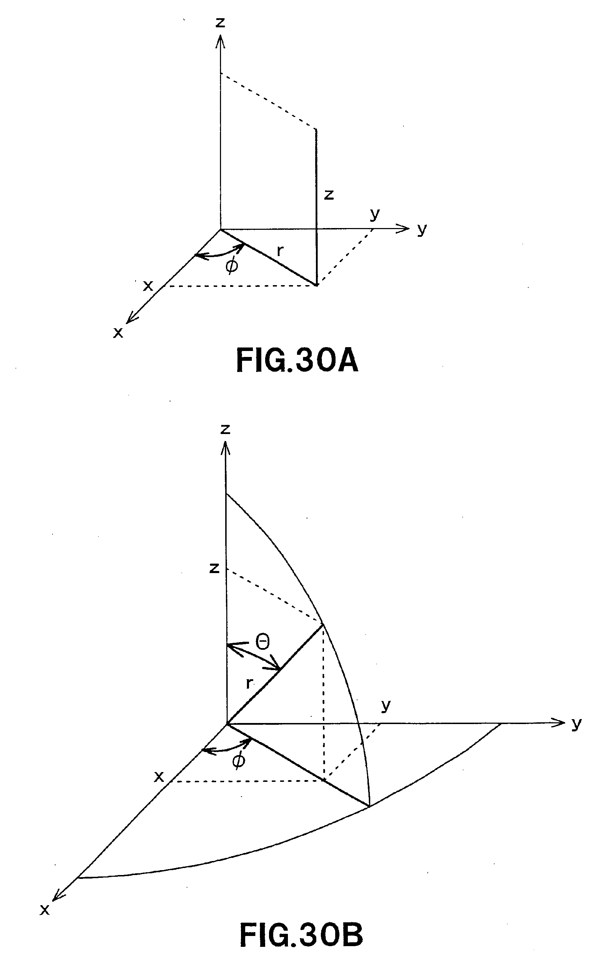

where the angle $\Theta$ is equivalent to a polar angle (= 90 deg. - horizontal angle). It should be noted that the cylindrical coordinate $(r, \phi, z)$ and polar coordinate $(r, \Theta, \phi)$ are referred to FIGS. 30A and 30B.

In each light-emitting element assembly 1 (1A, 1R, 1G, 1B), the top face 15 of the lens 10 is formed from an aspheric surface rotational symmetric with respect to the z-axis and convexed toward the surface light source to totally reflect a part of a component, whose polar angle is smaller than the polar angle $\Theta_0$ at the intersection between the lateral and top surfaces 14 and 15, of light emitted at a half of a whole solid angle from the light-emitting diode 20 (30). Also, the lateral face 14 of the lens 10 is formed from an aspheric surface rotational symmetric with respect to the z-axis and convexed outwardly to be pervious to a component, whose polar angle is smaller than the polar angle $\Theta_0$, of the light emitted at the half of the whole solid angle from the light-emitting diode 20 (30) and a light component totally reflected by the top face 15. It should be noted that the part of the component, whose polar angle is smaller than the polar angle $\Theta_0$ at the intersection between the lateral and top surfaces 14 and 15, of light emitted at a half of a whole solid angle from the light-emitting diode 20 - (30) is totally reflected by a part of the top face 15 (will also be referred to as "total-reflecting part of the top face" wherever appropriate hereunder), while the other part of the emitted light component whose polar angle is smaller than the polar angle $\Theta_0$ at the intersection between the lateral and top surfaces 14 and 15 is projected to outside from a part of the top face 15 (will also be referred to as "emitted light component-projecting part of the top face" wherever appropriate hereunder). It should also be noted that the "emitted light component-projecting part of the top face" is inside the "total-reflecting part of the top face".

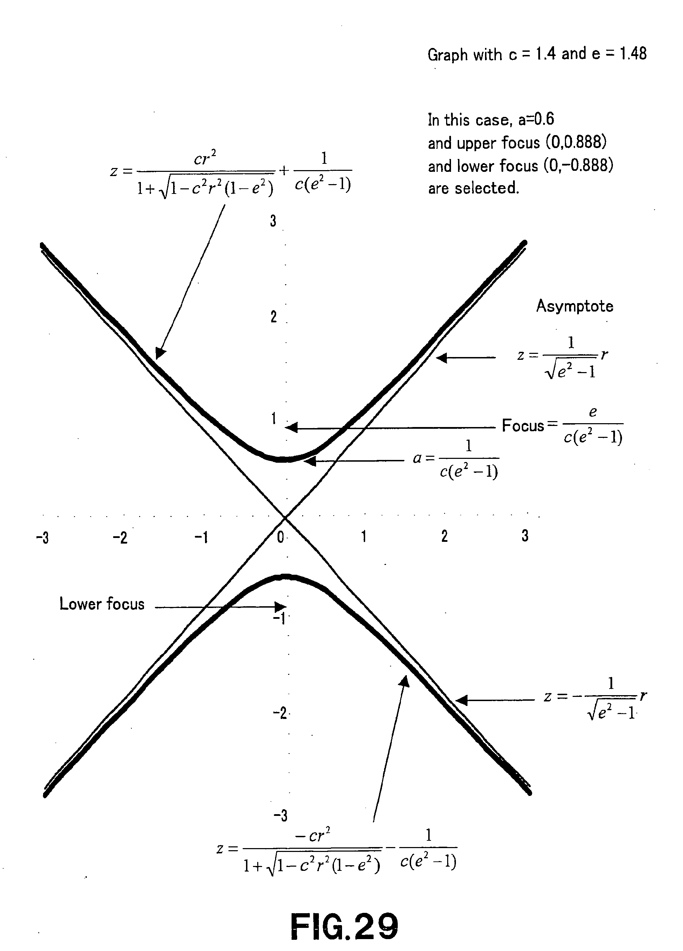

More specifically, according to Embodiment 1, the function $z = f_T(r)$ in which "r" defining the top face 15 formed from the aspheric surface is a variable is given by the aforementioned expression (1). It is a hyperboloid as shown in FIG. 29. In the expression (1), "c" is a value of the curvature (vertex curvature) at the vertex where the hyperboloid intersects with the z-axis, "e" is an eccentricity and the 0-order coefficient "a" is given by $a = [c(e^2 - 1)]^{-1} + p$ where "p" is a constant (p = 0 in Embodiment 1). It should be noted that the origin (= 0, 0, 0) of the cylindrical coordinate $(r, \phi, z)$ is in between two focuses of the hyperboloid of revolution. "$1/c = c^{-1}$" is a radius of curvature. The coordinate of the two focuses of the hyperboloid of revolution is given by $(0, 0, \pm a \cdot e)$. On the other hand, the lateral face 14 works as a convex lens and the center of the bottom face (center point) is located nearly at the focal distance of the lateral face 14 as a convex lens. The function $r = f_s(z)$ in which "z" defining a lateral face 14 formed from an aspheric surface is a variable is defined by an nth-order polynomial. More specifically, in the cylindrical coordinate $(r, \phi, z)$, the rotational symmetric aspheric surface forming the lateral face 14 is a toric (toroidal) surface defined by a fourth-order polynomial given by the following expression (3):

$$r = f_S(z) + k'_0$$
$$= k_4 \cdot z^4 + k_3 \cdot z^3 + k_2 \cdot z^2 + k_1 \cdot z + k_0 + k'_0 \qquad \ldots\ldots\ldots \quad (3)$$

The function $r = f_s(z)$ in which "z" defining the lateral face 14 formed from the aspheric surface is a variable will monotonously increase as "$\underline{z}$" decreases in a closed zone defined by "$0 \leq z \leq z_1$" when the z-coordinate of a part where the lateral face 14 intersects with the top face 15 is $z_1$, and it has at least one point where the second-order differential coefficient $|d^2r/dz^2|$ of "z" is maximum in the closed zone (more specifically, one in Embodiment 1).

In each light-emitting element assembly 1 (1A, 1R, 1G and 1B) embodied in the third mode of the present invention, the lateral face 14 of the lens 10 is formed from a curved surface symmetric with respect to an axis (z-axis) passing through the center point $P_0$ of the bottom face 11 and perpendicular to the bottom face 11 and convexed outwardly, as shown in FIG. 2. Also, the top face 15 is formed from a curved surface symmetric with respect to the axis (z-axis) and convexed toward the bottom face 11. When the center point $P_0$ is taken as the vertex, the cone angle (solid angle) of the first virtual cone $C_1$ tangent to the top face is taken as $\Omega_1$ and the cone angle (solid angle) of the second

virtual cone $C_2$ intersecting with the top face is taken as $\Omega_2$, the following requirement is satisfied:

(1) A component, existing inside the second virtual cone $C_2$, of virtual light assumed to have been projected from the center point $P_0$ is projected to outside from the top face 15.
(2) A component, existing outside the second virtual cone $C_2$ but inside the first virtual cone $C_1$, of the virtual light assumed to have been projected from the center point $P_0$ is totally reflected by the top face 15 and projected to outside from the lateral face 14.
(3) A component, positioned outside the first virtual cone $C_1$, of the virtual light assumed to have been projected from the center point $P_0$ is projected to outside from the lateral face 14.

It should be noted here that the cone angle (solid angle) $\Omega_1$ has a value of 0.37 $\pi$radians and the cone angle (solid angle) $\Omega_2$ has a value of 0.09 $\pi$radians. Also, the perpendicular line from the vertex of the first virtual cone $C_1$ to the bottom of the first virtual cone $C_1$ coincides with the z-axis, and the perpendicular line from the vertex of the second virtual cone $C_2$ to the bottom of the second virtual cone $C_2$ coincides with the z-axis. When a cone generating angle formed between the second virtual cone $C_2$ and a virtual plane cutting the second virtual cone and including the axis (z-axis) is $\theta_2$ and an angle formed between the lens 10 and a virtual plane cutting the lens and including the axis (z-axis) and at which a line Q normal to the top face 15, passing through a point P where the second virtual cone $C_2$ and top face 15 intersect with each other is $\theta_0$, the cone angle (solid angle) $\Omega_2$ will satisfy a requirement "$\sin (\theta_2 + \theta_0) = (n_0/n_1)$". It should be noted that $Q_2 = 2\pi [1-\cos(\theta_2)]$. The top face 15 is a hyperboloid of revolution given by the aforementioned expression (1). On the other hand, the lateral face 14 also works as a convex lens and center point is positioned nearly at the focal distance of the lateral face 14 as the convex lens. The rotational symmetric curved surface forming the lateral face 14 is defined by an nth-order polynomial. More specifically, in the cylindrical coordinate (r, $\phi$, z), the rotational symmetric curved surface forming the lateral face 14 is a toric (toroidal) surface defined by the aforementioned expression (3). In the following explanation, the origin of the cylindrical coordinate (r, $\phi$, z) coincides with the center point. The center point (origin = (r, $\phi$, z) = (0, 0, 0)) is positioned in a range between the midpoint between the two focuses of the hyperboloid of revolution and one of the focuses. The coordinate of the other focus in the expression (1) is given by "(0, 0, [e/{(e$^2$-1)c} + p])". Also, when the cone generating angle formed between the first virtual cone $C_1$ and a virtual plane cutting the first virtual cone $C_1$ and including an axis (z-axis) is $\theta_1$, the polar angle $\Theta_0$ and cone generating angle $\theta_1$ is in a relation of "$\Theta_0 = 90 - \theta_1$".

The values of "c", "e", "a", "p" and "$\Theta$" in the expression (1) and coefficients in the expression (3) are as shown in Table 1. These values were determined by simulation. The unit of the value "$\Theta$" is "degree" and unit of the other values is "mm". Also, the size $\underline{d}$ of the surface light source was d = 1.0 mm.

Table 1

$\Theta_0 = 53° [\tan(\Theta_0) = (1.52 + 0.5)/1.52]$

c = 1.4

e = 1.48

p=0

a = 0.6

$k_4$= -0.34465

$k_3$ = 0.33555

$k_2$ = -0.28581

$k_1$ = 0.019736

$k_0$ = 1.2824

$k'_0$ = 1.5200

With the values of "$\Theta$", "c", "e", "a", "p" and "a" and those of $k_4$, $k_3$, $k_2$, $k_1$, $k_0$ and $k'_0$ being set as shown in Table 1, a part of a component, totally reflected at the top face 15 and guided to the lateral face 14, of light emitted from the light-emitting diode 20 (30) can be allowed to pass by the lateral face 14 without being totally reflected at the lateral face 14, and an increased proportion of light emitted from the light-emitting diode 20 (30) can be totally reflected at the top face 15. It should be noted however that these values are shown just as examples here and even with other values, a part of the component, totally reflected at the top face 15 and guided to the lateral face 14, of the light emitted from the light-emitting diode 20 (30) can be allowed to pass by the lateral face 14 without being totally reflected at the lateral face 14, and an increased proportion to the light emitted from the light-emitting diode 20 (30) can be totally reflected at the top face 15.

It is assumed here that the intersection in the first quadrant between the two aspheric surfaces of revolution defined by the aforementioned expressions (1) and (3), respectively, having the values shown in Table 1 is $P_1(r_1, \phi, z_1)$. On the other hand, the end of the surface light source has a coordinate "(0.5, $\phi$ + $\pi$, 0), (0.5, $\phi$, 0)" because d = 1.0 mm. Such values "c" and "e" of the expression (1) will be selected that a straight line $O_1P_1$ connecting an end "$O_1$ (0.5, $\phi$ + $\pi$, 0)" of the surface light source and intersection $P_1$ to each other is nearly tangent to the top face 15. For a better understanding, the above will be explained concerning the x-z plane. The intersection $P_1$ is ($x_1$, $z_1$) and the end $O_1$ of the surface light source is (-0.5,0). In the following explanation, a point A ($\alpha$, $\phi$ + $\pi$, z) in the expression of a cylindrical coordinate is given by "(-$\alpha$, $\phi$, z)" in some cases. That is, "(0.5, $\phi$ + $\pi$, 0)" is given by "(-0.5, $\phi$, 0)" as the case may be.

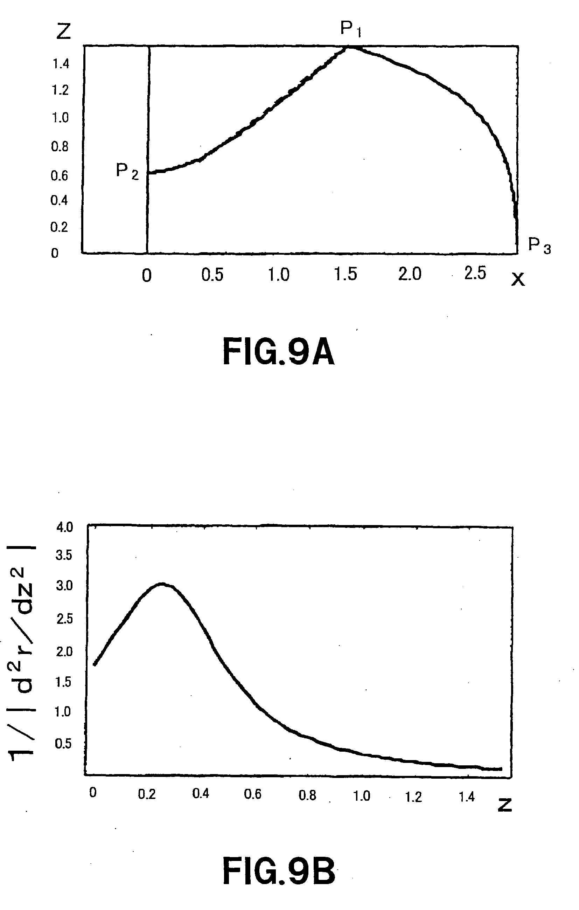

FIG. 9A illustrates the visible outlines, taken along the x-z plane, of the lateral and top faces 14 and 15 of the lens 10 having curved surfaces defined by the expressions (1) and (3) having the values shown in Table 1 (outlines of the lateral and top faces 14 and 15, taken as the x-z plane as a plane including the z-axis. It should be noted that the scale unit is "mm". Also, FIG 9B graphically illustrates a reciprocal ($1/|d^2r/dz^2|$) of the absolute value of second-order differential coefficient of nth-order polynomial (expression (3)) defining the rotational symmetric curved surface forming the lateral face 14 of the lens 10. In FIG. 9B, the abscissa indicates the value (in mm) of the z-coordinate while the ordinate indicates the reciprocal ($1/|d^2r/dz^2|$) of the absolute value of second-order differential coefficient of "z". The absolute value of the second-order differential coefficient has a maximum when z = 0.23 and polar angle $\Theta_1$ = 85.3 deg (4.7 deg. in horizontal angle).

The intersection $P_1$ is ($r_1$, $\phi$, $z_1$) in the first quadrant between the two aspheric surfaces of revolution defined by the aforementioned expressions (1) and (3), respectively, having the values shown in Table 1 takes a value shown below. Also, since in the expression (3), r = 2.8024 mm when z = 0, the diameter of the bottom face 11 of the lens 10 is 5.6 mm, and the value of an intersection "$P_3(r_3, \phi, z_3)$" in the first quadrant defined between the aspheric surface of revolution defined by the expression (3) and plane of z = 0 and that of a intersection "$P_4(r_4, \phi, z_4)$" between the aspheric surface of revolution defined by the expression (3) and plane of r = 0 are given below. Further, since in the expression (1), z = a = 0.6 mm when r = 0, the value an intersection "$P_2(r_2, \phi, z_2)$ " between the aspheric surface of revolution defined by the expression (1) and z-axis is as follows:

$$P_1(r_1, z_1) = (1.52, \phi, 1.52)$$

$$P_2(r_2, z_2) = (0, \phi, 0.6)$$

$$P_3(r_3, z_3) = (2.8024, \phi, 0)$$

$$P_4(r_4, z_4) = (0, \phi, 1.842)$$

The geometric relation between the light source and two aspheric surfaces of revolution (top and lateral faces 15 and 14) limits the range in which the coefficients in the expression (1) can take various values.

For the two aspheric surfaces of revolution (top and lateral faces 15 and 14) to intersect with each other, the following expression (4) should be satisfied when the intersection between the lateral face 14 and z-axis is taken as $Z_{max}$ (= $z_4$):

When p = 0,

$$0 < a = [c(e^2 - 1)]^{-1} < z_{max} \ (=z_4) \qquad \dots \dots \dots \dots \quad (4)$$

When p ≠ 0,

$$0 < a = [c(e^2 - 1)]^{-1} + p < z_{max} \ (=z_4) \qquad \dots \dots \dots \dots \quad (4)$$

In the expression (1) having the values shown in Table 1, $z_{max} = z_4 = 1.842$. On the other hand, the above inequality expression (4) is satisfied because $p = 0$ and $a = 0.6$.

The value of $z_F$, in a position $(0, 0, z_F)$, of the focus (other focus) of the hyperboloid of revolution forming the top face 15 is $z_F = a \times e + p$. For the position $(0, 0, Z_F)$ of the focus (other focus) of the hyperboloid of revolution forming the top face 15 to be nearer to the origin than the intersection $Z_{max}$ $(= Z_4)$ between the toric (toroidal) surface forming the lateral face 14 and z-axis, the following expression (5) should be satisfied when $p = 0$:

When $p = 0$,

$$0 < a \times e = e \times [c(e^2 - 1)]^{-1} < z_{max}\ (=z_4) \qquad \ldots\ldots\ldots\ldots \ (5)$$

When $p \neq 0$,

$$0 < a \times e = e \times [c(e^2 - 1)]^{-1} + p < z_{max}\ (=z_4) \qquad \ldots\ldots\ldots\ldots \ (5)$$

where $z_{max} = z_4 = 1.842$. Since $a \times e = 0.888$ when $p = 0$, the expression (5) is satisfied.

For a point where the top and lateral faces 15 and 14 intersect with each other to exist (that is, the value "r" of the r-coordinate is significant, in other words, for the value "r" to be r > 0), the upper limit of "a" in the inequality expression (4) should be smaller than $z_{max} = z_4$. When the value $z_1$ of the z-coordinate of the intersection between the aspheric surfaces of revolution given by the expressions (1) and (3), respectively, is taken as the upper limit of "a" in the inequality expression (4), the rightmost side of the expression (5) will be "$z_1$". It should be noted that when $p = 0$, $z_1/z_{max} = 0.825$. Namely, the rightmost side $z_1$ may be given by $z_{max}$ as follows:

$$z_1 = 0.825 \cdot z_{max}$$

$$0 < a \times e = e \times [c(e^2 - 1)]^{-1} < z_1 = 0.825 \cdot z_{max} \qquad \ldots\ldots\ldots\ldots \ (5')$$

The relation between the size $\underline{d}$ of the surface light source and the lens 10 will be discussed below. The intersection between an asymptote of the expression (1) "$z = r/(e^2 - 1)^{1/2}$" and expression (3) provides the intersection $P_1(r_1, z_1)$ between the top and lateral faces 15 and 14. That is, the asymptote of the expression (1) provides as follows:

$$z_1 = r_1/(e^2 - 1)^{1/2} \qquad \ldots\ldots\ldots\ldots \ (6\text{-}1)$$

or

$$r_1 = z_1 \cdot (e^2 - 1)^{1/2} \qquad \ldots\ldots\ldots\ldots \ (6\text{-}2)$$

The requirement given by the following expression (7) for the value "a" to be lager than a z-segment "$z_2 = z_1 d/(2r_1 + d)$" of the straight line $O_1P_1$ connecting "$O_1\ (-d/2, \phi, 0)$" and intersection $P_1$ to each other should be satisfied on the assumption that $p = 0$:

$$a = [c(e^2 - 1)]^{-1} > z_2 = z_1 d/(2r_1 + d) \qquad \ldots\ldots\ldots\ldots \ (7)$$

Therefore, a range common to the expressions (5') and (7) is given by the following expression (8) on the assumption that $p = 0$:

$$z_1 d/(2r_1 + d) = z_2 < a = [c(e^2 - 1)]^{-1} < z_1/e = 0.825 \cdot z_{max}/e \quad ............ \quad (8)$$

The following expression (9) equivalent to the expression (2) will be derived from the expressions (8) and (6-2):

$$c^{-1}_{min} \equiv [\{(e^2 - 1)z_1\}/\{1 + 2(e^2 - 1)^{1/2}(z_1/d)\}] \leq c^{-1} \leq [(e^2 - 1)z_1/e] \equiv c^{-1}_{max}$$

$$............ \quad (9)$$

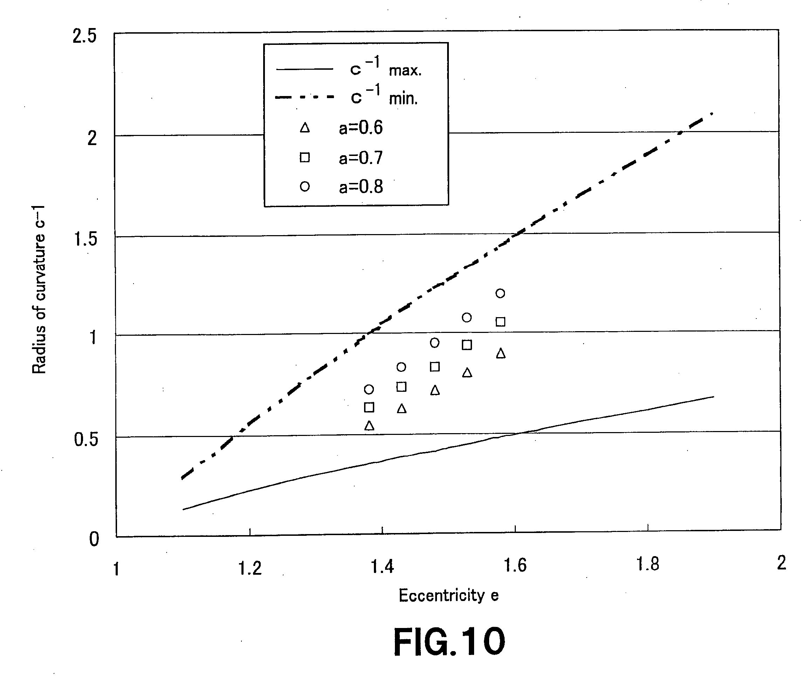

FIG 10 graphically illustrates results of plotting of a radius of curvature $c^{-1}$ satisfying the conditional expression (9) with the <u>eccentricity e</u> being taken as an independent variable when $z_{max} = 1.842$ mm and d = 1.0 mm.

A point, corresponding to e = 1.48, in a point sequence shown in FIG. 10 has a value adopted in the expression (1) having the values shown in Table 1, and each of other points is a combination ($c^{-1}$, e) having the same value "a". The smaller the eccentricity <u>e,</u> the nearer the position of the focus (other focus) in the expression (1) is to the vertex of the hyperboloid of revolution, the smaller the angle at which the emitted light component totally reflected at the top face 15 is incident upon the lateral face 14 is so that the light component is more difficult to be totally reflected at the lateral face 14, the larger the value of the r-coordinate of the intersection between the top and lateral faces 15 and 14 is, the more the component of the light emitted at a half of a whole solid angle from the surface light source is totally reflected at the top face 15, and the less the component of the light emitted at a half of a whole solid angle from the surface light source is incident directly upon the lateral face. When the <u>eccentricity e</u> is larger, the above will be inverted.

In other words, the top face 15 is given by the expression (1), but the larger the eccentricity <u>e,</u> the nearer the focus position is to the vertex $P_2$ of the hyperboloid of revolution and the less the hyperboloid of revolution is inclined. Therefore, the light totally reflected at the top face 15 is incident upon the lateral face 14 at a larger angle. However, the value of the cone angle (solid angle) $\Omega_1$ of the first virtual cone will increase, the amount of luminous flux of light totally reflected at the top face 15 and projected from the lateral face 14 to outside will increase, and the amount of luminous flux of the light, existing outside the first virtual cone, of light assumed to have been projected from the center point will decrease. On the other, the smaller the eccentricity <u>e,</u> the above will be inverted.

If the radius of curvature $c^{-1}$ exceeds a corresponding value "$c^{-1}_{max}$" when an eccentricity <u>e</u> is given, the focus position (other focus) is beyond the intersection $P_1(r_1, z_1)$ between the top and lateral faces 15 and 14 so that the emitted light component totally reflected at the top face 15 will be incident upon the lateral face 14 at an excessively large angle and be totally reflected at the lateral face 14 and the proportion of light component not projected from the lateral face 14 of the lens 10 will be excessively larger, which is inappropriate. On the other hand, if the radius of curvature $c^{-1}$ is less than a corresponding value "$c^{-1}_{min}$" when an eccentricity <u>e</u> is given, an excessively lager part, which would normally be incident directly upon the lateral face 14, of the emitted light component will be scattered, which is also inappropriate.

The requirement for the top face 15 to be nearly tangent to the straight line $O_1P_1$, in other words, for selection of such a shape of the top face 15 that the straight line $O_1P_1$ will be asymptotic to the top face 15, is intended for minimizing scattering, by the top face 15, of the emitted light component incident directly upon the lateral face 14. Thus, in addition to the hyperboloid of revolution, a paraboloid of revolution is also effectively usable as the aspheric surface forming the top face 15.

The lateral face 14 is formed from a toric (toroidal) surface given by the expression (3) having the values shown in Table 1 for the purpose of leading out light from the light source $O_1O_2$ with a highest efficiency at a predetermined polar angle $\Theta_1$. It should be noted that the function $r = f_s(z)$ defining the lateral face 14 having the values of coefficients shown in Table 1 was obtained by simulation. The function $r = f_s(z)$ will monotonously decrease when the lateral face 14 passes by the points $P_1(r_1, \phi, z_1)$ and $P_3(r_3, \phi, z_3)$ and the value "z" decreases in the closed zone defined by "$0 \leq z \leq z_1$", and it has at least one point where the absolute value $|d^2r/dz^2|$ of the second-order differential coefficient of "z" is maximum in the closed zone, which satisfies a kind of boundary condition. The lens 10 is to project the emitted light from the light-emitting diode 20 (30) corresponding to the surface light source horizontally thereof (two-dimensional or in-plane projection). For such a two-dimensional projection or in-plane projection, the polar angle $\Theta_1$ should preferably be about 90 deg. According to the theory of solid-angle projection in the illumination engineering, the above is attainable by maximizing a solid angle $\Omega$ facing the light source $O_1O_2$ through the light lea-out lens 10 from a far point positioned in the direction of the polar angle $\Theta_1$. To this end, it is necessary to form the lateral face 14 of the lens 10 as an aspheric lens when it is viewed from the direction of the polar angle $\Theta_1$.

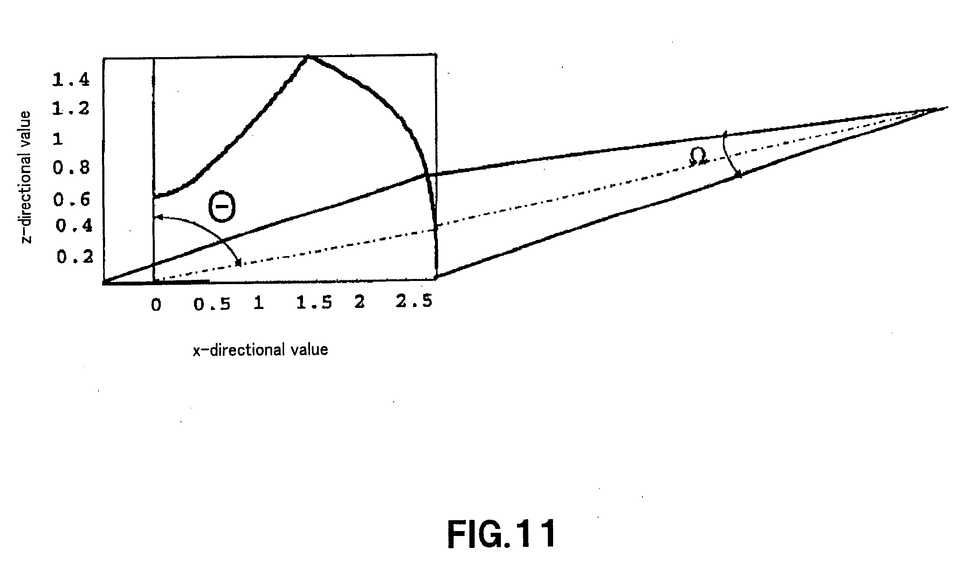

That is, as shown in FIG. 11 showing the lateral and top faces 14 and 15 taken along the x-z plane including the z-axis, the lens surface of the aspheric lens (more specifically, lateral face 14) is formed so aspheric that it will be positioned inside a circumcircle of the lens surface (more specifically, lateral face 14) at the intersection between the aspheric lens (more specifically, lateral face 14) and main ray of light from the surface light source as it is away from the intersection. Thus, as when light emitted from the surface light source is formed at a fat point, rays of light away from the main one will be incident at a gradually larger angle and refracted at a gradually larger angle, whereby the solid angle $\Omega$ can be maximized. It should be noted that the abscissa of the graph in FIG. 11 indicates an x-directional distance from the origin while the ordinate in FIG. 11 indicates a z-directional distance from the origin.

In the expression (3) having the values shown in Table 1, the reciprocal "$1/|d^2r/dz^2|$" of the second-order differential coefficient of "z" in the closed zone defined by $0 \leq z \leq z_1$ is as shown in FIG. 9B. As will be known, the absolute value $|d^2r/dz^2|$ of the second-order differential coefficient of "z" is maximum around a point of z = 0.23. With such a value of the z-coordinate, a peak will take place in the projection-angle distribution of the light emitted from the surface light source.

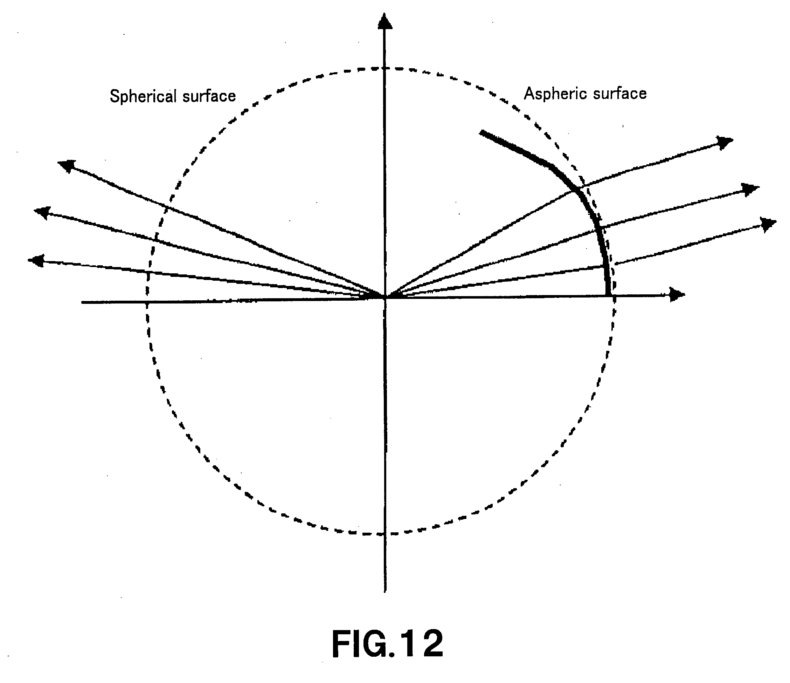

On the other hand, in case the lateral face formed from a spherical surface is defined by a polar coordinate as shown in FIG. 30B, the absolute value $|d^2r/d\Theta^2|$ of a second-order differential coefficient of "$\Theta$" has evidently no maximum and the projection-angle distribution is uniform. Namely, as shown in FIG. 12, forming the lateral face 14 aspheric permits to provide an angular peak of the projection-angle distribution directive in a specific angular direction. It should be noted that of FIG. 12, the left half indicates a spherical surface while the right half indicates an aspheric surface. The spherical surface will not work as a lens with respect to a point light source positioned at the center of the spherical surface before the spherical surface is formed aspheric. The light source formed from the light-emitting diode 20 (30) is a surface one. Also in this case, the lateral face 14 should be formed aspheric similarly to the spherical lateral face positioned in relation to the point light source. In case the spherical surface and radius of curvature of the aforementioned circumcircle are somewhat larger the stretch of a surface light source, the projection-angle distribution is given an angular peak by forming the lateral face 14 aspheric. In this case, the larger the size $\underline{d}$ of the surface light source in relation to the radius of curvature of the spherical surface or circumcircle, the larger the stretch of the angular peak is.

Further, because of the geometric property of a hyperboloid of revolution, a virtual surface light source is generated based on the top face 15. The virtual surface light source is generally formed near the focus (other focus) of the hyperboloid of revolution. Of the hyperboloid of revolution given by the expression (1) having the values shown in Table 1, the other focus is positioned at a point of "a x e = 0.888 mm" on the z-axis. Therefore, when the lens 10 is viewed from outside, the entire surface light source has a stretch of $\pm 0.5$ mm (namely, -0.5 mm to +0.5 mm) in the x- and y-directions and 0.888 mm (namely, 0 mm to 0.888 mm) in the z-direction.

The diameter of the bottom face 11 of the lens 10 is approximately 5.6 mm as having previously been described. Also, the size d of the surface light source is $\pm 0.5$ mm in the x- and y-directions. Therefore, the ratio between the diameter of the bottom face 11 of the lens 10 and size of the surface light source is 5.6/1. By making similitude-expansion of the aspheric surface shape given by the expression (1), namely, by increasing the ratio between (diameter of the bottom face 11 of the lens 10) and (size of the surface light source), the directivity will further be improved but the entire lens 10 will be larger in side. It is necessary to find a middle ground between the similitude expansion and directivity.

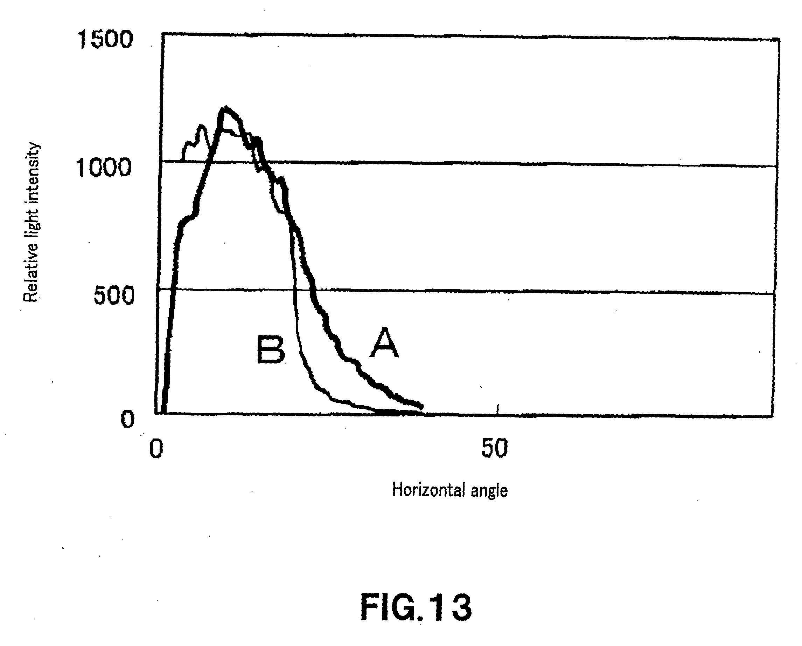

FIG. 13 graphically illustrates results of calculation of the distribution of angles at which the light component is projected from the lateral face 14 of the lens 10 according to Embodiment 1 in case the lateral face 14 is given by the expression (3) having the value shown in Table 1. It should be noted that the abscissa of FIG. 13 indicates a horizontal angle (= 90 deg. - polar angle). Here are calculated refractive indexes $n_1$ of a material of the lens 10, which are 1.50 (indicated with a curve B in FIG. 13) and 1.74 (indicated with a curve A in FIG 13). It should be noted that the more approximate the refractive index $n_1$ is to the refractive index of the light-emitting diode 20 (30) or a substrate 21 (will further be explained later) included in the light-emitting diode 20 (30), the higher the efficiency of optical coupling between the lens 10 and light-emitting diode 20 (30) becomes and the larger the intensity of the light projected from the lens 10 becomes. In the calculation of the projection-angle distribution, however, the light intensity is normalized for comparison with attention being paid only to the projection-angle distribution. It will be apparent that when the refractive index $n_1$ of the material of the lens 10 is higher, the width of the horizontal angle-based projection-angle distribution is reduced and the projection-angle distribution of emitted light component has a peak at a large horizontal angle.

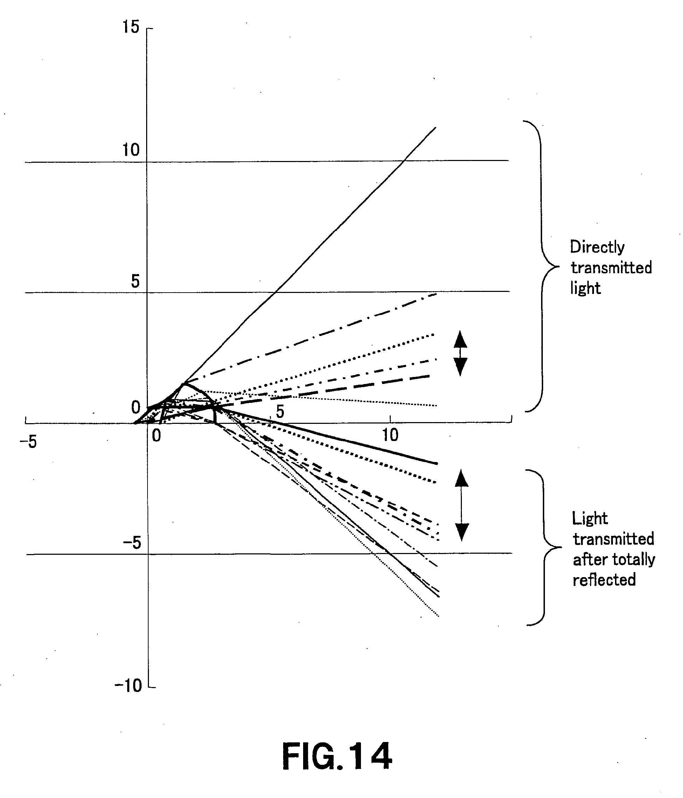

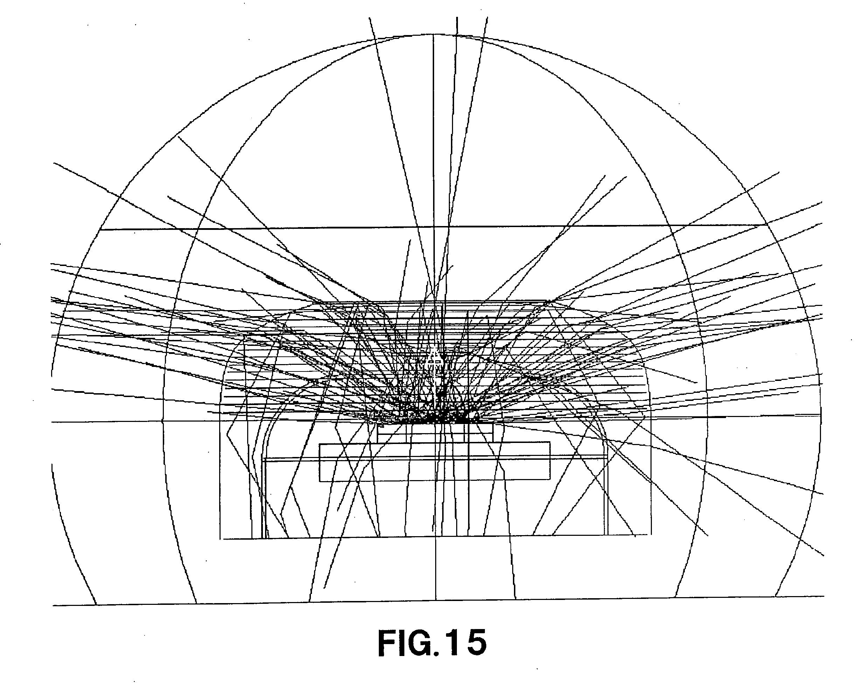

On the assumption that a point light source disposed at the center point of the lens 10 having the top and lateral faces 15 and 14 given by the aforementioned expressions (1) and (3), respectively, and also at positions shifted 0.6 mm and -0.6 mm in the x-direction from the center point, it is confirmed whether the emitted light component totally reflected at the top face 15 given by the expression (1) having the values shown in Table 1 is not totally reflected at the lateral face 14. FIG. 14 shows results of calculation of a light-ray tracking in the x-z plane including the z-axis when the refractive index $n_1$ of the material of the lens 10 is 1.74. Also, FIG. 15 shows results of simulation of how light emitted from a surface light source having a stretch of 0.6 mm in the x-y direction is projected from the lateral and top faces 14 and 15 of the lens 10. It can be confirmed that the emitted light component totally reflected at the top face 15 travels for projection from near the other focus (a $\times$ e = 0.888 mm) of the hyperboloid of revolution. That is, the emitted light component totally reflected at the top face 15 may be regarded as being projected from the virtual surface light source. It should be noted that FIG. 14 shows also the emitted light component projected directly at the lateral face 14.

As will be known from the results of simulation, when the luminous-flux amount of light assumed to have been projected from the emitted light component-projecting portion of the top face to outside (luminous-flux amount of light assumed to have been projected as it is from the center point to outside via the top face) is $LF_T$ and luminous-flux amount of light assumed to have been projected as it is from the center point to outside via the lateral face (luminous-flux amount of other light assumed to have been projected to outside finally via the lateral face) is $LF_S$, there is a relation as follows:

$$LF_S/(LF_S + LF_T) = 0.894$$

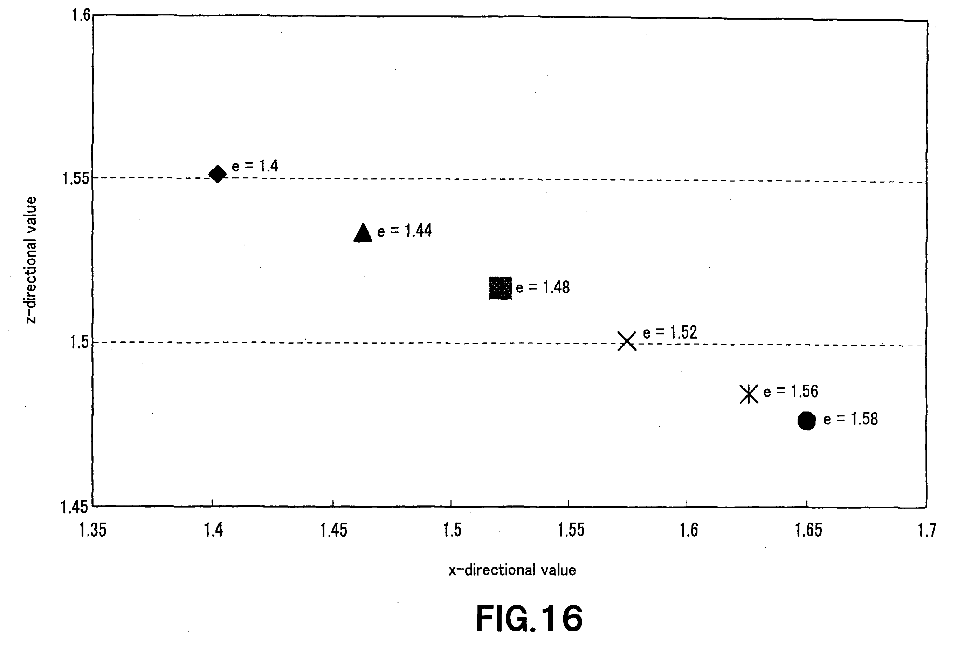

FIG 16 graphically illustrates results of determination of an intersection between the top and lateral faces 15 and 14 in the x-z plane with the value of "a" being fixed at 0.6, for example, and eccentricity $e$ being taken as a parameter. As shown in FIG. 16, as the eccentricity $e$ is smaller, the top face 15 will be smaller in area while the lateral face 14 will be larger in area. As the eccentricity $e$ is larger, the top face 15 will be large in area while the lateral face 14 will be smaller in area. Also, as shown in FIG. 16, "1.40" was selected as the lower limit of the eccentricity $e$ and "1.58 was as the upper limit of the eccentricity $e$.

Of the light emitted from ends (-d/2, $\phi$, 0) and (d/2, $\phi$, 0) of the surface light source, the light component emitted from one (-d/2, $\phi$, 0) of the ends, totally reflected at the top face 15 and projected from the lower end of the lateral face 14 without being totally reflected at the lateral face 14 (maximum horizontal angle of the light component is taken as "$\alpha$") and light component emitted from the other end (d/2, $\phi$, 0), totally reflected at the top face 15 and projected from the lateral face 14 without being totally reflected at the lateral face 14 (maximum horizontal angle of the light component is taken as "$\beta$") will be defined as "marginal light components". When viewed from outside, the lens 10 faces the surface light source at an angle $\omega$ formed between these marginal light components (will be referred to as "lead-out angle $\omega$" hereunder). So, when the lead-out angle $\omega$ takes a maximum value, the emitted light component is led out with a highest efficiency through the top face 15 of the lens 10 according to the theory of solid-angle projection.

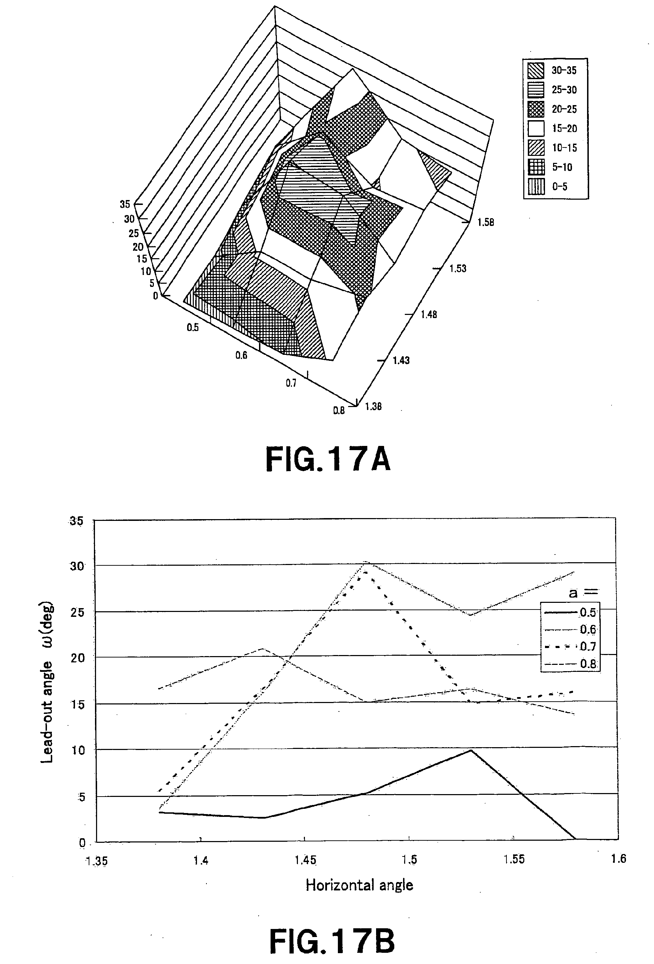

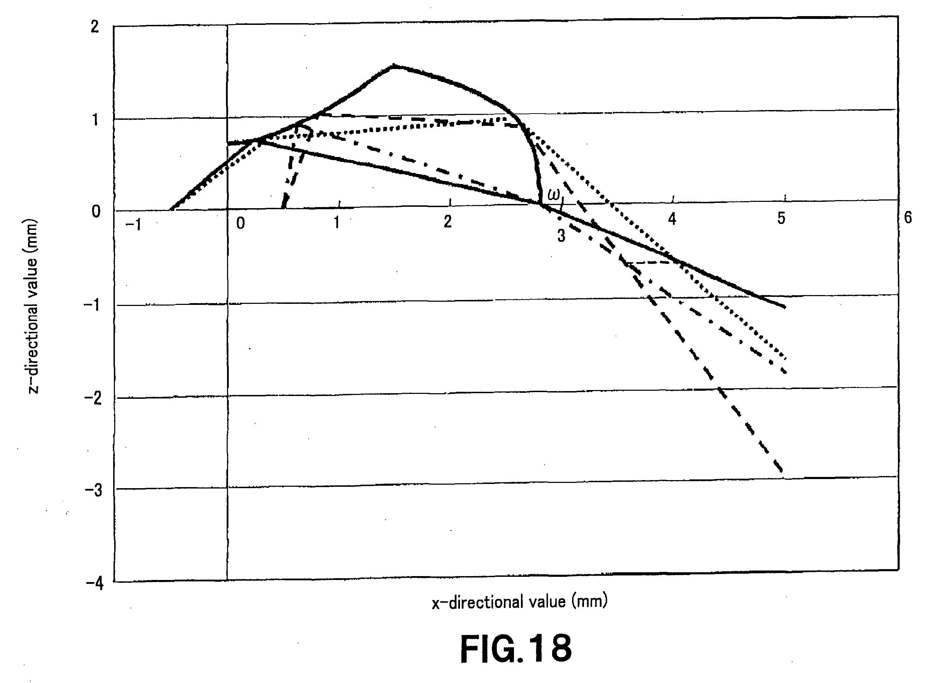

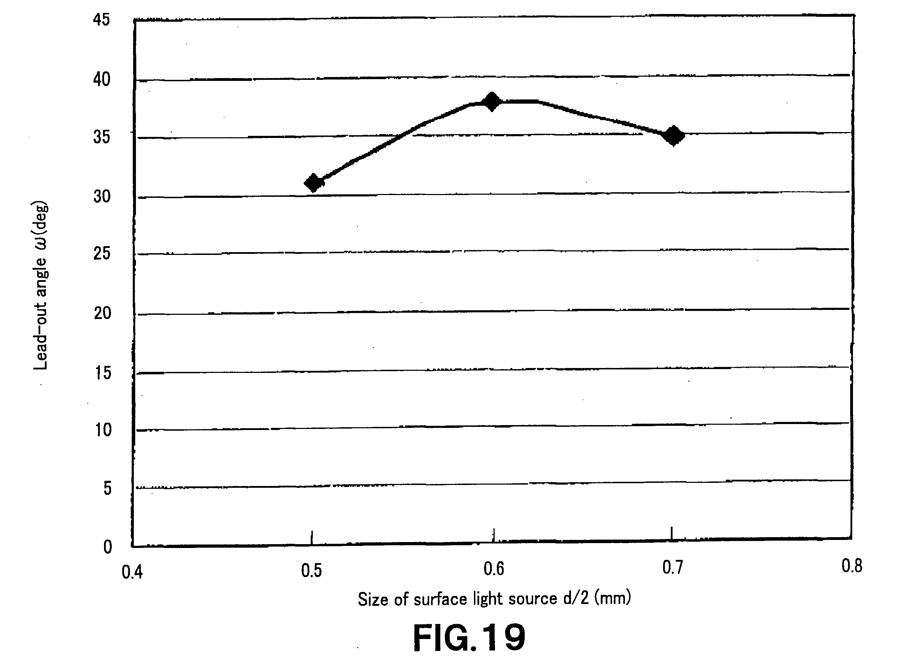

FIGS. 17A and 17B graphically illustrate results of calculation of an angle $\omega$ at which the light is led out when the eccentricity $e$ and value of "a" in the expression (1) defining the top face 15 are varied with the size $d$ of the light source being d = 1.0 mm. As will be known from FIGS. 17A and 17B, when (a, e) = (0.7, 1.48), the lead-out angle $\omega$ is 30.9 deg. FIG. 18 shows light paths along which marginal light components projected from one end (-0.5, $\phi$, 0) and other end (0.5, $\phi$, 0), respectively, of the surface light source when (a, e) = (0.7, 1.48). Further, FIG. 19 graphically illustrates results of calculation, made on the assumption that (a, e) = (0.7, 1.48), of the lead-out angle $\omega$ for the marginal light components projected from one end (-0.5, $\phi$, 0) and other end (0.5, $\phi$, 0), respectively, of the surface light source, a lead-out angle $\omega$ for the marginal light components projected from one end (-0.6, $\phi$, 0) and other end (0.6, $\phi$, 0), respectively, of the surface light source, and a lead-out angle $\omega$ for the marginal light components projected from one end (-0.7, $\phi$, 0) and other end (0.7, $\phi$, 0), respectively, of th surface light source.

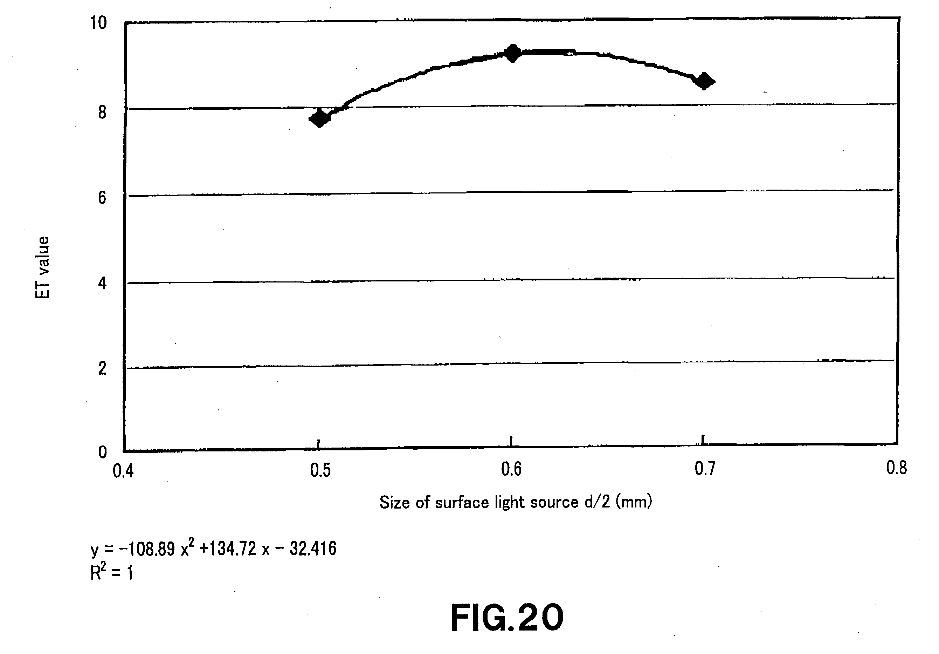

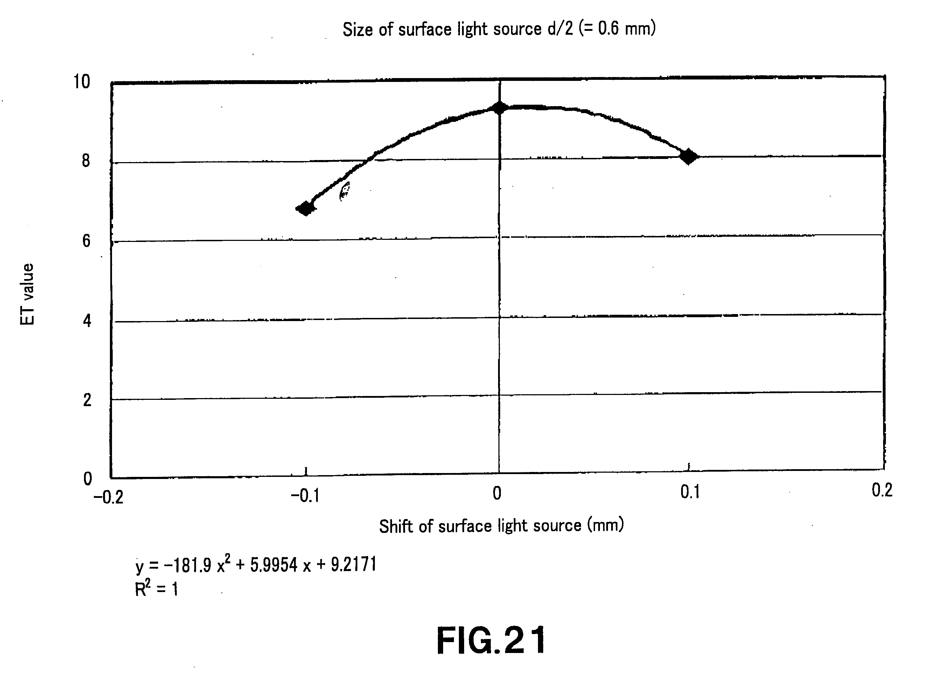

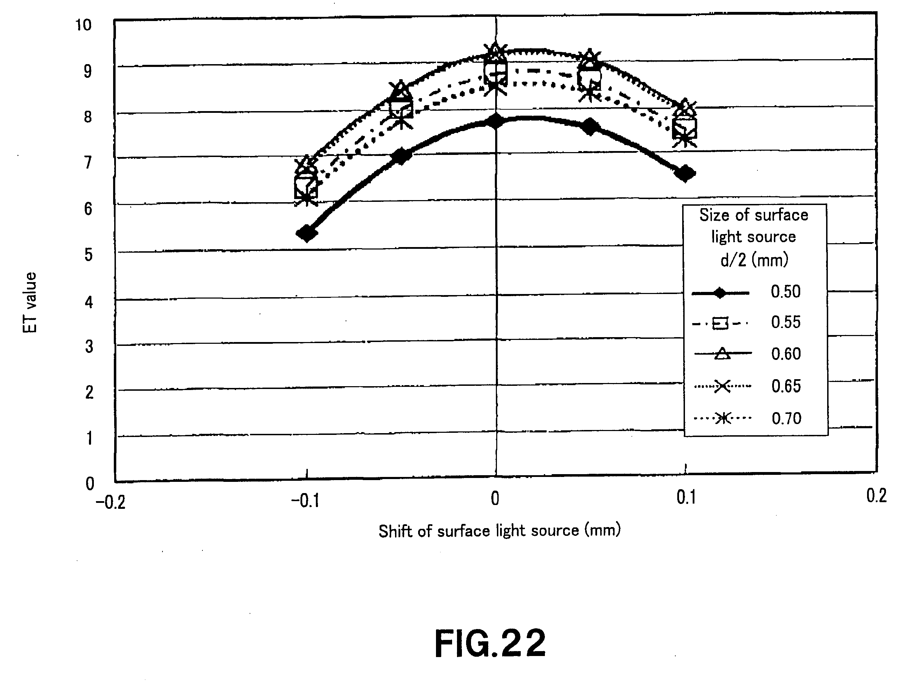

As shown in FIG. 19, when the surface light source is 1.2 mm in size (d), the lead-out angle $\omega$ (angle of the marginal light component) takes a maximum value. However, when the size $d$ of the surface light source is varied, the angles of projection (maximum horizontal angle) "$\alpha$" and "$\beta$" will also possibly be varied. FIG. 20 graphically illustrates plotting of a performance function ET "$(\alpha + \beta)\omega$" being a product of a kind of mean value $(\alpha + \beta)$ of the angles of projection (maximum horizontal angle) "$\alpha$" and "$\beta$" and a lead-out angle $\omega$ with the size of the surface light source being taken as a variable. The performance function ET (= $(\alpha + \beta)\omega$) varies by $\pm 1.2$ mm like a quadratic function with respect to the size $d$ of the surface light source. The quadratic function is also shown in FIG. 20. FIG 21 graphically illustrates results of calculation, made on the assumption that the size $d$ of the surface light source is 1.2 mm, of change in ET function when the surface light source is moved -0.1 mm and 0.1 mm, respectively, in relation to the lens 10 in an observing direction (x-direction) from a state in which the axis of the lens 10 coincides with that of the surface light source. The ET function varies by $\pm 0.0$ mm like a quadratic function with respect to a shift of the surface light source in relation to the lens 10 in the observing direction (x-direction). The quadratic function is also shown in FIG. 21. When the surface light source is 1.2 mm in size $d$, a shift of $\pm 0.1$ mm or less (positioning error) of the surface light source in relation to the lens 10 in the observing direction (x-direction), resulted from a variation of the performance function ET, is allowable on the assumption that an ET value when the axis of the lens 10 and that of the surface light source coincide with each other is a reference value and 80% of this reference value is allowable. It should be noted that the ET value when the axis of the lens 10 and that of the surface light source coincide with each other is taken as a reference value and an allowable shift of surface light source in relation to the lens 10 in the observing direction (x-direction) when 80% of the reference value is allowable will expediently be called "allowable shift of surface light source" herein. FIG. 22 graphically illustrates results of determination of the allowable shift of surface light sources different in size from each other. As shown in FIG. 22, when the size $d$ of the surface light source is 1.2 mm, the allowable shift of surface light source takes a maximum value. On the other hand, when the size $d$ of the surface light source is 1.0 mm, the allowable shift of surface light source takes a maximum value.

The aforementioned lens 10 according to Embodiment 1 can lead out an emitted light component with an improved efficiency because the emitted light component totally reflected at the top face 15 is projected from the lateral face 14 and the source of the emitted light component projected from the lateral face 14 is a surface light source and virtual surface light source. Also, the top face 15 is a hyperboloid of revolution convexed toward the surface light source and having not any particularity. Because of this simple structure, the lens can easily be taken out from an injection-molding die assembly by opening this assembly and the lens is not likely to be defective (cracking) when being taken out of the molding die assembly, for example. As having been described in the foregoing, by selecting a combination (0.7, 1.48) as (a, e) in case the lens 10 has the top and lateral faces 15 and 14 given by the expressions (1) and (3), respectively, it is possible to totally reflect a larger emitted light component at the top face 15 when the size $\underline{d}$ of the surface light source is within a range of 1.0 mm to 1.4 mm, and to maximize the allowable shift of surface light source.

The gallium nitride-made light-emitting diode (LED) 20 as the light-emitting element according to Embodiment 1 includes a substrate 21 and light-emitting layer 22 formed on the substrate 21 as shown in FIG. 4A or 6B. The light-emitting layer 22 includes a first clad layer of a first conductive type (n type, for example) compound semiconductor, active layer formed on the first clad layer and a second clad layer formed on the active layer and formed from a second conductive type (p type, for example) compound semiconductor (all not shown). The substrate 21 forming a red light-emitting diode that emits red light (of 640 nm in wavelength, for example) is formed from $G_aA_s$ (3.4 in refractive index $n_S$), and substrate 21 forming a green light-emitting diode that emits green light (of 530 nm in wavelength, for example) or blue light-emitting diode that emits blue light (of 450 nm in wavelength, for example) is formed from $G_aN$ (2.438 in refractive index $n_S$) or alumina (1,78 in refractive index $n_S$), respectively. It should be noted that the composition, construction and structure of the light-emitting layer 22 included in each light-emitting diode may be well-known ones.

Light from the light-emitting layer 22 is projected to outside through the substrate 21. A part of the bottom face 11 of the lens 10 is in contact with the substrate 21 included in the light-emitting diode 20 via a light-transparent medium layer (not shown). That is, the structure shown in FIG 4A or 6B is a so-called flip-chip structure.

The first clad layer has electrically connected thereto a first electrode 23A which is connected via a gold bump 24A to a first wire 25A provided on a support 26. Also, the second clad layer has electrically connected thereto a second electrode 23B which is connected via a gold bump 24B to a second wire 25B provided on the support 26. The first and second wires 25A and 25B are connected to a light-emitting element drive circuit (not shown). The light-emitting element is driven by a pulse width modulation (PWM) signal from the light-emitting element drive circuit or by a CC signal from a constant current circuit.

The light-emitting diode 20 is housed in a light-emitting diode fixture 12.

On the other hand, the gallium nitride-made light-emitting diode (LED) 30 as the light-emitting element according to Embodiment 1 includes a substrate 31 and a light-emitting layer 32 formed on the substrate 31 as shown in FIG. 4B. The light-emitting layer 32 is similar in construction and structure to the light-emitting layer 22, and the substrate 31 is also similar in construction and structure to the substrate 21. A part of the bottom face 11 of the lens 10 is in contact with the light-emitting layer 32 included in the light-emitting diode 30 via a light-transparent medium later 38. That is, the structure shown in FIG. 4B is a so-called face-up structure. It should be noted that the substrate 31 is fixed to a support 36 via a silver-paste payer 37.

The first clad layer has electrically connected thereto a first electrode 33A which is connected via a gold jumper wire 34A to a first wire 35A provided on the support 36. Also, the second clad layer has electrically connected thereto a second electrode 33B which is connected via a gold jumper wire 34B to a second wire 35B provided on the support 36. The first and second wires 35A and 35B are connected to a light-emitting element drive circuit (no shown), and the light-emitting element is driven by a pulse width modulation (PWM) signal from the light-emitting element drive circuit or by a CC signal from a constant-current circuit.

It should be noted here that

The light-transparent medium layer may be of an epoxy resin (1.5 in refractive index, for example) transparent to light emitted from the light-emitting element, gel-state material (OCK-451 by Nye (1.51 in refractive index) or OCK-433 by Nye (1.46 in refractive index), for example) or an oil compound such as silicon rubber, silicon oil compound (TSK5353 by Toshiba Silicon (1.45 in refractive index), for example).

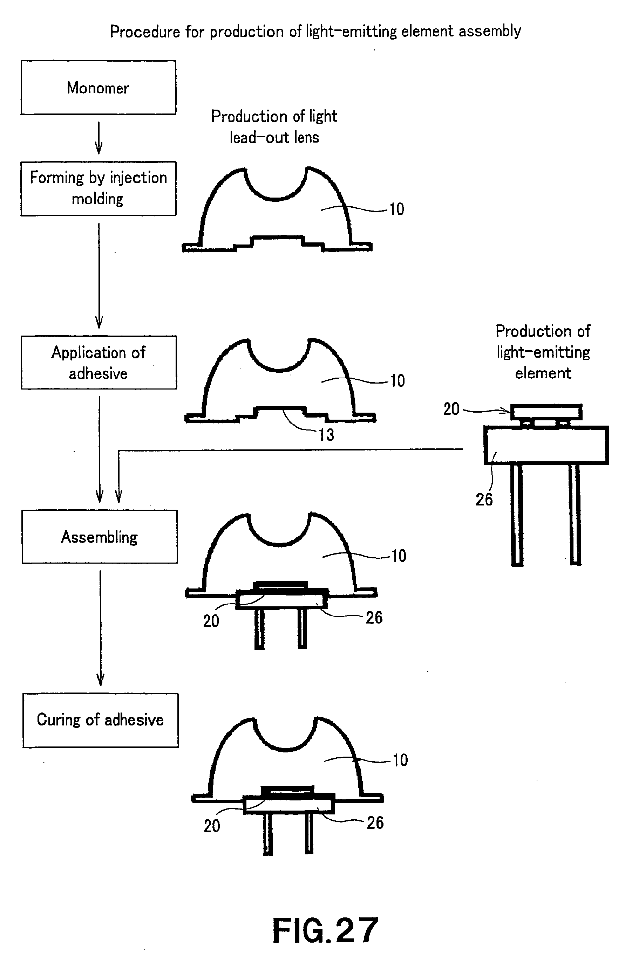

FIG 27 shows a flow of operations made in the procedure for production of the light-emitting element assembly according to Embodiment 1. The lens 10 (formed from a plastic material, for example) shown in FIGS. 3 and 5A may be formed by the injection molding, for example. More specifically, a melted resin is injected into an injection-molding die assembly, it is solidified, and the die assembly is opened for removal of the lens 10. The lens 10 is simple in shape and can thus be removable easily from the die assembly. Namely, it can thus be produced massively with a high productivity. Also, it can be produced with an extremely low possibility of variation in shape and very freely from defect (cracking). It should also be noted that a flange 16 formed at the end portion of the lateral face 14, which will not contribute for leading out the light will permit easier removal of the product from the die assembly and also easier installation of the light-emitting element assembly to the surface light source device. Thereafter, an adhesive (also functioning as a light-transparent medium layer) made of a transparent epoxy resin transparent to light emitted from the light-emitting diode is applied to a concavity 13 of the lens 10 or substrate 21 of the light-emitting diode 20 and cured with the lens 10 being disposed on the substrate 21 in close optical contact with the latter, whereby the light-emitting diode 20 can be secured to the lens 10. It should be noted here that since the size of the light-emitting diode 20 is sufficiently smaller than that the support 26, securing only the light-emitting diode 20 to the lens 10 permits to reduce the strain of the lens 10 due to heat developed when the light-emitting diode 20 is in operation, which will assure a designed performance of leading out the light. The above may also generally be true with the light-emitting diode 30.

As shown in FIG. 7B, the surface light source device 70 includes a housing 71 formed from an outer frame 73 and inner frame 74. The transparent type color liquid crystal display 40 is held tight at the end thereof on the outer and inner frames 73 and 74 with spacers 75A and 75B laid between them. Also, with a guide member 76 being disposed between the outer and inner frames 73 and 74, the color liquid crystal display 40 held tight on the outer and inner frames 73 and 74 will not be displaced. A diffusion plate 81 is installed to the inner frame 74 at an upper portion inside the housing 71 with a spacer 75C and bracket member 77 being laid between them. Also, a group of optical-functional sheets including a diffusion sheet 82, prism sheet 83, polarization sheet 84, etc. is stacked on the diffusion plate 81.

Further, a reflecting sheet 85 is provided at a lower portion inside the housing 71. The reflecting sheet 85 is disposed with its reflecting surface being opposite to the diffusion plate 81 and in a position lower than the bottom of the lens 10, and installed to the bottom 72A of the housing 71 with a fixing member (not shown) being laid between them. The reflecting sheet 85 may be formed from, for example, an enhanced silver reflecting film formed from a silver reflecting film, low refractive-index film and high refractive-index film stacked in this order. The reflecting sheet 85 reflects light projected from the lens 10 and light reflected at the lateral surface 72B of the housing 71. Thus, red light, green light and blue light emitted from a plurality of red light-emitting element assemblies 1R which emits red light, plurality of green light-emitting element assemblies 1G which emits green light and plurality of blue light-emitting element assemblies 1B which emits blue light are mixed together to provide white light, whose color purity is high, as illumination light. The illumination light passes by the group of optical-functional sheets including the diffusion plate 81, diffusion sheet 82, prism sheet 83, polarization sheet 84, etc., and is projected from the back of the color liquid crystal display 40.

A plurality of sets each including the red light-emitting element assembly 1R, green light-emitting element assembly 1 G and blue light-emitting element assembly 1B may be successively laid horizontally to form an array of light-emitting element assemblies, and a plurality of the light-emitting assembly arrays may be disposed vertically Each set of the light-emitting element assemblies include, for example, two red light-emitting element assemblies, two green light-emitting element assemblies and one blue light-emitting element assembly, and the light-emitting element assemblies are disposed in the order of the red light-emitting element assembly, green light-emitting element assembly, blue light-emitting element assembly, green light-emitting element assembly and red light-emitting element assembly.

As shown in the fragmentary sectional view in FIG. 8, the color liquid crystal display 40 includes a front panel 50 provided with a transparent first electrode 54, read panel 60 provided with a transparent second electrode 64 and a liquid crystal material 41 disposed between the front and rear panels 50 and 60.

The front panel 50 includes, for example, a first substrate 51 formed from glass and a polarization film 56 provided on the outer surface of the first substrate 51. Further, the front panel 50 has provided on the inner surface of the first substrate 51 thereof a color filter 52 coated with an overcoat layer 53 of acrylic resin or epoxy resin, the transparent first electrode 54 (also called "common electrode" and formed from ITO, for example) is formed on the overcoat layer 53 and an aligned film 55 is formed on the transparent first electrode 54. On the other hand, the rear panel 60 includes, for example, a second substrate 61 formed from glass, a switching element 62 formed on the inner surface of the second substrate 61 (more specifically, a thin-film transistor (TFT)), a transparent second electrode 64 (also called "pixel electrode"; it is formed from ITO, for example) of which the on/off state is controlled by the switching element 62, and a polarization film 66 provided on the outer surface of the second substrate 61. An aligned film 65 is formed over the rear panel 60 including the transparent second electrode 64. The front and rear panels 50 and 60 are joined at their peripheries to each other with a sealant (not shown) being laid between them. It should be noted that the switching element 62 may not always be formed from TFT but may be formed from an MIM element, for example. The reference numeral 67 in FIG. 8 indicates an insulating layer provided between the switching elements 62.

It should also be noted that various members and liquid material of the transparent type color liquid crystal display may be well-known ones and so they will not be explained in detail herein.

Embodiment 2:

Embodiment 2 is a variant of Embodiment 1. In Embodiment 2, the expression (3) defining the lateral face 14 in Embodiment 1 was altered into an expression (10) which will be given below. However, the function $f_s(z)$ is the same as that having been explained concerning Embodiment 1 and the coefficients $k_0$ to $k_4$ are same in value as those in Table 1. In Embodiment 2, the value "$\alpha$" in the expression (10) is given by "$0 \leq \alpha \leq 0.875$". It should be noted that when $\alpha = 0$, the lateral face 14 is the same as that in Embodiment 1.

$$r = (1 - \alpha) \cdot f_S(z) + k'_0 \qquad \dots\dots\dots \quad (10)$$

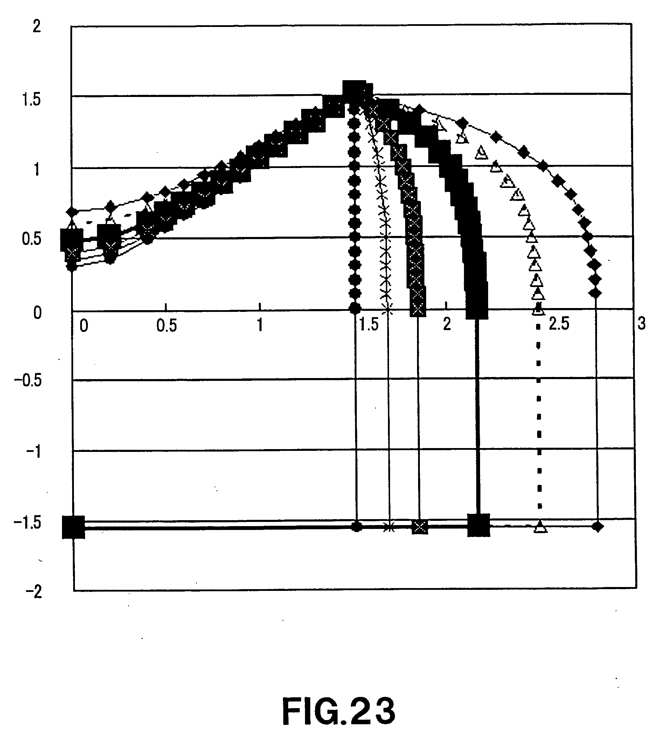

When $\alpha$ is 0, 0.25, 0.50, 0.75, 0.875 or 1.00, the expression (10) is given by "$P_1$ ($r_1$, $z_1$) = (1.52, 1.52)". The value of $k'_0$ was determined for the lateral face 14 given by the expression (10) to intersect with that given by the expression (1). FIG. 23 shows visible outlines of the lateral and top faces, taken along the x-z plane, of the lens. In FIG. 23, a straight line extending vertically from a point where the x-coordinate value is 1.52 indicates $\alpha$ = 1.00 and an area where the x-coordinate value is larger than 1.52 includes five curves of which the z-coordinate value decreases. The five curves indicate $\alpha$ = 0.875, $\alpha$ = 0.75, $\alpha$ = 0.5, $\alpha$ = 0.25 and $\alpha$ = 0 from left to right. Also, since the value of "$\alpha$" is varied, the direction of light emission is somewhat varied. Accordingly, the top face is slightly corrected in shape. An optimum correction value is determined by changing the top-face shape little by little via simulation.

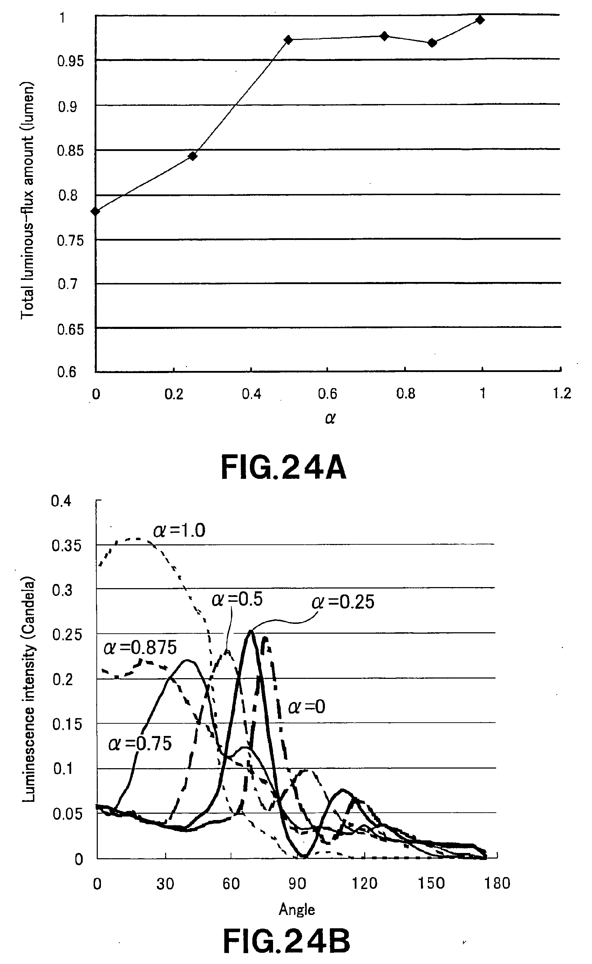

FIG. 24A graphically illustrates results of calculation of the total luminous-flux amount from the lens in which "$\alpha$" is taken as a parameter, made on the assumption that the size of the light-emitting surface of the light-emitting diode is 1.0 mm x 1.0 mm, and FIG. 24B graphically illustrates of calculation of a far-field program (FFP). It should be noted that the ordinate of the graph in FIG. 24A indicates the value of "$\alpha$" while the abscissa indicates the total luminous-flux amount (in lumen). On the other hand, the ordinate of the graph in FIG 24B indicates the angle formed in relation to the z-axis while the abscissa indicates the luminescence intensity (in candela).

As will be known from FIG. 24A, when the value of "$\alpha$" exceeds 0.5, a very large total luminous-flux amount can be obtained. On the other hand, as will be seen from FIG. 24B, when the value of "$\alpha$" exceeds 0.75, the angle formed between a component sharing a considerable part of the light projected from the lens 10 and the z-axis will be less than 45 deg. so that the light projection in the two-dimensional direction cannot sufficiently be attained.

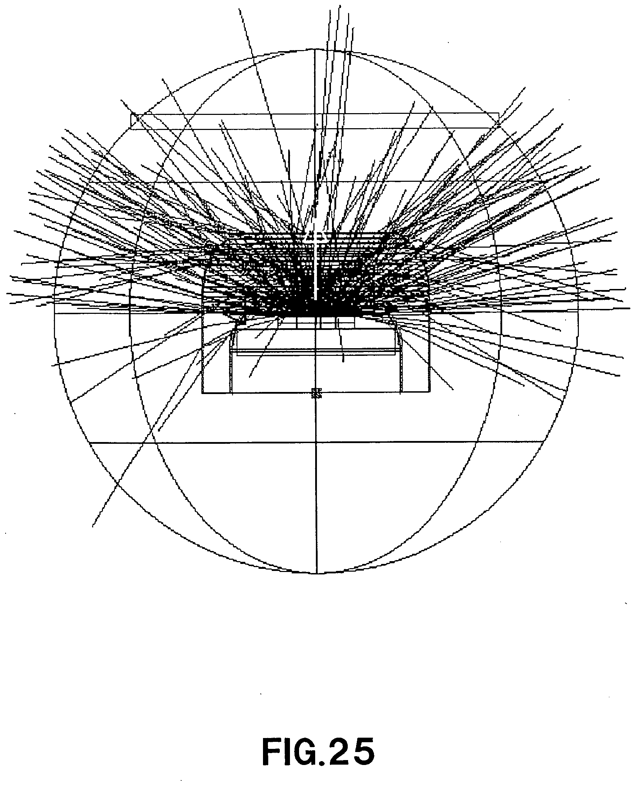

The values of "c", "e" and "a" and value of "p" in the expression (1) and value of "$\alpha$" and coefficients in the expression (10) are as shown (in mm) in Table 2. FIG. 25 shows results of simulation of how light emitted from a point source is projected from the top and lateral faces 15 and 14 of the lens 10, defined by the expressions (1) and (10), respectively, made on the assumption that the point source is disposed at the center point of the lens 10 having the lateral and top faces 14 and 15. It should be noted that the value of "p" was determined via simulation.

Table 2:

c = 1.87582

e = 1.4528

p = 0

a = 0.48

a=0.5

$k_4$ = -0.34465

$k_3$ = 0.33555

$k_2$ = -0.28581

$k_1$ = 0.019736

$k_0$ = 1.2824

$k'_0$ = 0.0093

In the foregoing, the present invention has been explained concerning the preferred embodiments. However, the present invention is not limited only to such preferred embodiments. The shape, construction, structure and material of each of the lens and light-emitting element assembly having been explained in the foregoing are just examples and may be changed appropriately. Also, the construction and structure of the surface light source device and color liquid crystal display assembly having been explained in the foregoing are just examples and may be changed appropriately.

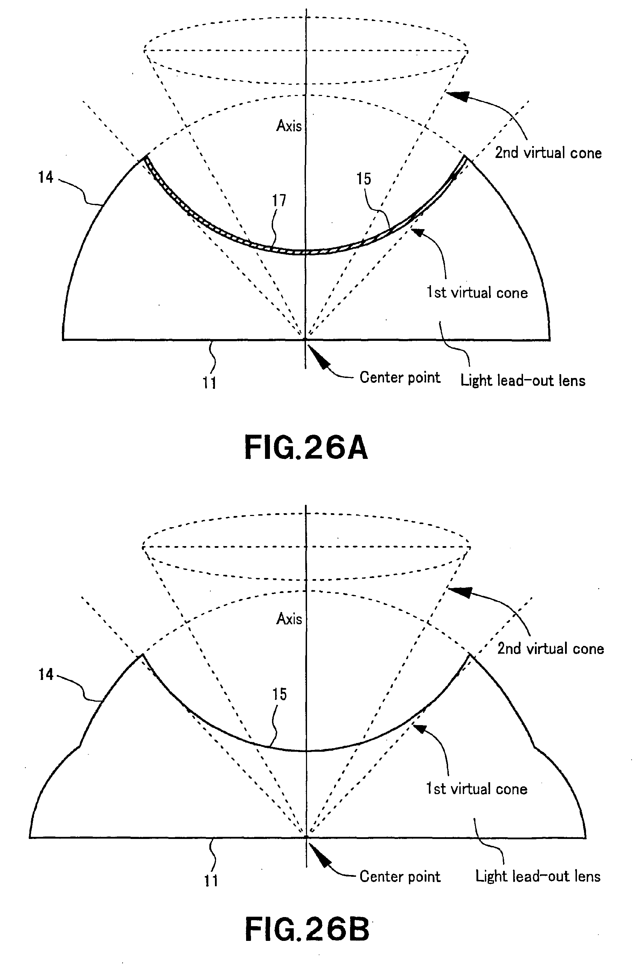

For example, the present invention will be described herebelow concerning the third mode thereof, for example. As shown in the conceptual diagram in FIG. 26A, a reflecting layer 17 formed from a multilayer dielectric layer structure may be formed on the outer surface of a part of the top face included in at least the second virtual cone (over the outer surface of the top face 15 in the illustrated example). More specifically, the reflecting layer is formed from a multilayer structure including an $SiO_2$ layer and $TiO_2$ layer. With such a construction, a component, existing inside the second virtual cone, of virtual light assumed to have been projected from the center point will be reflected at the reflecting layer 17, not projected from the top face 15 to outside. The light reflected at the reflecting layer 17 is projected from the lateral face 14 or bottom face 11. Although the lateral face 14 is a curved surface defined by one function in Embodiments having previously been explained, it may be a curved surface defined by a plurality of functions (two functions in the illustrated example) as shown in the conceptual diagram in FIG. 26B.

In the foregoing, the present invention has been described in detail concerning certain preferred embodiments thereof as examples with reference to the accompanying drawings. However, it should be understood by those ordinarily skilled in the art that the present invention is not limited to the embodiments but can be modified in various manners, constructed alternatively or embodied in various other forms without departing from the scope and spirit thereof as set forth and defined in the appended claims.

**Claims**

1. A lens formed from circular bottom, lateral and top faces and having a surface light source of a finite size provided at the center of the bottom face thereof, wherein
   in an assumed cylindrical coordinate $(r, \phi, z)$ of which the origin is the center of the bottom face and z-axis is a normal line passing through the center of the bottom face,
   the top face is an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and
   the lateral face is an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source,
   a function $r = f_s(z)$ where $\underline{z}$ is a variable representing the aspheric lateral face increasing monotonously as the variable z decreases in a closed zone defined by $0 \leq z \leq z_1$ when the z-coordinate of the intersection between the lateral and top faces is $Z_1$, and having at least one point where an absolute value $|d^2r/dz^2|$ of a second-order differential coefficient of the variable z takes a maximum value in the closed zone.

2. The lens of claim 1, wherein the function $r = f_T(r)$ where r is a variable representing the top face being an aspheric surface defines a hyperboloid given by the following expression (1):
   where "c" is a curvature (vertex curvature) at the vertex where the hyperboloid intersects with the z-axis, "e" is an eccentricity and the zero-order coefficient "a" is given by an expression "a = $[c(e^2 - 1)]^{-1}$ + p" where "p" is a constant.

3. The lens of claim 2, wherein
   the eccentricity e satisfies "$1.40 \leq e \leq 1.58$", and
   "c" satisfies the following expression (2)
   when the size of the surface light source is taken as $\underline{d}$.

4. The lens of claim 1, wherein the function $r = f_s(z)$ where z is a variable representing the lateral face being an aspheric surface is defined by an nth-order polynomial.

5. The lens of claim 1, wherein the refractive index, taken as $n_1$, of the material of the lens is $1.48 \leq n_1 \leq 2.5$.

6. A lens formed from circular bottom, lateral and top faces and having a surface light source of a finite size disposed at the center of the bottom face thereof, wherein
   in a cylindrical coordinate $(r, \phi, z)$ assumed for the lens and of which the origin is the center of the bottom face and z-axis is a normal line passing through the center of the bottom face,
   the top face is an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and
   the lateral face is an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source.

7. The lens of claim 6, wherein the bottom face is centered nearly at the focal distance of the lateral face that effectively functions as a convex lens.

8. A lens formed from circular bottom, lateral and top faces and having a light-emitting element disposed at the center of the bottom face thereof, wherein
   the lateral face of the lens is a curved surface convexed outwardly and symmetric with respect to an axis of revolution which is an axis passing through the center point of the bottom face and perpendicular to the bottom face,
   the top face is a curved surface convexed toward the bottom face and symmetric with respect to the axis of revolution, and

on the assumption that the cone angle of a first virtual cone having the vertex thereof defined by the center point and being tangent to the top face is $\Omega_1$ and the cone angle (solid angle) of a second virtual cone having the vertex thereof defined by the center point and being tangent to the top face is $\Omega_2$,

a component, existing inside the second virtual cone, of virtual light assumed to have been projected from the center point is projected from the top face to outside,

a component, existing outside the second virtual cone but inside the first virtual cone, of the virtual light assumed to have been projected from the center point is totally reflected at the top face and projected to outside from the lateral face, and

a component, existing outside the first virtual cone, of the virtual light assumed to have been projected from the center point is projected from the lateral face to outside.

9. The lens of claim 8, wherein on the assumption that the refractive index of the material of the lens is $n_1$ and that of the outer medium is no, a cone generating angle formed between the second virtual cone and a virtual plane cutting the second virtual cone and including the axis is $\theta_2$ and an angle formed between the lens and a virtual plane cutting the lens and including the axis and at which the line normal to the top face, passing through a point where the second virtual cone and top face intersect with each other is $\theta_0$, the cone angle (solid angle) $\Omega_2$ ($= 2\pi [1-\cos(\theta_2)]$) will satisfy a requirement "$\sin(\theta_2 + \theta_0) = (n_0/n_1)$".

10. The lens of claim 9, wherein $n_0 = 1.00$ and $1.48 \leq n_1 \leq 2.5$.

11. The lens of claim 8, wherein on the assumption that an amount $LF_T$ of a light component assumed to have been projected from the center point to outside through a top-face portion from which the emitted light is projected and amount $LF_S$ of a light component assumed to have been projected from the center point to outside through the lateral face satisfy a requirement "$0 \leq LF_S/(LF_S + LF_T) \leq 0.84$".

12. The lens of claim 8, wherein
the top face is a hyperboloid of revolution, and
the center point is positioned within a range defined by a midpoint between two focuses of the hyperboloid of revolution and focus, at the convex side, of the hyperboloid of revolution inside the two focuses.

13. The lens of claim 8, wherein the lateral face effectively functions as a convex lens and the bottom face is centered nearly at the focal distance of the lateral face effective as the convex lens.

14. The lens of claim 13, wherein the rotational symmetric curved surface forming the lateral face is defined by an nth-order polynomial.

15. The lens of claim 14, wherein the absolute value of a second-order differential coefficient of the nth-order polynomial defining a rotational symmetric curved surface forming the lateral face within a range of the lateral face has at least one maximum.

16. The lens of claim 8, wherein
a reflecting layer is formed on the outer surface of a top-face portion included in at least the second virtual cone, and
a component, existing inside the second virtual cone, of the light assumed to have been projected from the center point is reflected at the reflecting layer, not being projected from the top face to outside.

17. A light-emitting element assembly including
a lens formed from circular bottom, lateral and top faces, and
a surface light source formed from a light emitting element provided at the center of the bottom face of the lens, wherein
in a cylindrical coordinate ($r, \phi, z$) assumed for the lens and of which the origin is the center of the bottom face and z-axis is a normal line passing through the center of the bottom face,
the top face is an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and
the lateral face is an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source,
a function $r = f_s(z)$ <u>where z</u> is a variable representing the aspheric lateral face increasing monotonously as the variable z decreases in a closed zone defined by $0 \leq z \leq z_1$ when the z-coordinate of the intersection between the lateral and top faces is $z_1$, and having at least one point where an absolute value $|d^2r/dz^2|$ of a second-order differential coefficient of the variable z takes a maximum value in the closed zone:

18. The light-emitting element assembly of claim 17, wherein
the light-emitting element is a light-emitting diode (LED) including a substrate and a light-emitting layer formed on the substrate, and
a part of the bottom face of the lens is in contact with the light-emitting layer included in the light-emitting diode with a light-transparent medium layer being laid between them (face-up structure).

19. The light-emitting element assembly of claim 17, wherein
the light-emitting element is a light-emitting diode (LED) formed from a substrate and a light-emitting layer formed on the substrate,
light emitted from the light-emitting layer is projected to outside, and
the part of the bottom face of the lens is in contact with the light-emitting layer included in the light-emitting diode with a light-transparent medium layer being laid between them (flip-chip structure).

20. A light-emitting element assembly including
a lens formed from circular bottom, lateral and top faces, and
a surface light source formed from a light emitting element provided at the center of the bottom face of the lens, wherein
in a cylindrical coordinate $(r, \phi, z)$ assumed for the lens and of which the origin is the center of the bottom face and z-axis is a normal line passing through the center of the bottom face,
the top face is an aspheric surface rotational symmetric with respect to the z-axis and which totally reflects a part of a component, whose polar angle is smaller than a polar angle $\Theta 0$ at the intersection between the lateral and top faces, of light emitted at a half of a whole solid angle from the surface light source, and
the lateral face is an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source.

21. The light-emitting element assembly of claim 20, wherein the center of the bottom face is positioned nearly at the focal distance of the lateral face that effectively functions as a convex lens.

22. A light-emitting element assembly including
a lens formed from circular bottom, lateral and top faces, and
a surface light source formed from a light emitting element provided at the center of the bottom face of the lens, wherein
of the lens, the lateral face is a curved surface convexed outwardly and symmetric with respect to an axis of revolution which is an axis passing through the center point of the bottom face and perpendicular to the bottom face, and
the top face is a curved surface convexed toward the bottom face and symmetric with respect to the axis of revolution, and
on the assumption that the cone angle of a first virtual cone having the vertex thereof defined by the center point and being tangent to the top face is $\Omega_1$ and the cone angle (solid angle) of a second virtual cone having the vertex thereof defined by the center point and being tangent to the top face is $\Omega_2$,
a component, existing inside the second virtual cone, of virtual light assumed to have been projected from the center point is projected from the top face to outside,
a component, existing outside the second virtual cone but inside the first virtual cone, of the virtual light assumed to have been projected from the center point is totally reflected at the top face and projected to outside from the lateral face, and
a component, existing outside the second virtual cone, of the virtual light assumed to have been projected from the center point is projected from the lateral face to outside.

23. The light-emitting element assembly of claim 22, wherein on the assumption that the refractive index of the material of the lens is $n_1$ and that of the outer medium is no, a cone generating angle formed between the second virtual cone and a virtual plane cutting the second virtual cone and including the axis is $\theta_2$ and an angle formed between the lens and a virtual plane cutting the lens and including the axis and at which the line normal to the top face, passing through a point where the second virtual cone and top face intersect with each other is $\theta_0$, the cone angle $\Omega_2$ satisfies the following requirement

$$\sin (\theta_2 + \theta_0) = (n_0/n_1).$$

**24.** The light-emitting element assembly of claim 22, wherein
the light-emitting element is a light-emitting diode including a substrate and a light-emitting layer formed on the substrate, and
a part of the bottom face of the lens is in contact with the light-emitting layer included in the light-emitting diode with a light-transparent medium layer being laid between them.

**25.** The light-emitting element assembly of claim 22, wherein
the light-emitting element is a light-emitting diode formed from a substrate and a light-emitting layer formed on the substrate,
light emitted from the light-emitting layer is projected to outside, and
the part of the bottom face of the lens is in contact with the light-emitting layer included in the light-emitting diode with a light-transparent medium layer being laid between them.

**26.** A surface light source device including a plurality of light-emitting element assemblies to emit red light, a plurality of light-emitting element assemblies to emit green light and a plurality of light-emitting element assemblies to emit blue light, wherein
each of the light-emitting element assemblies includes
a lens formed from circular bottom, lateral and top faces, and
a surface light source formed from a light emitting element provided at the center of the bottom face of the lens,
in a cylindrical coordinate $(r, \phi, z)$ assumed for the lens and of which the origin is the center of the bottom face and z-axis is a normal line passing through the center of the bottom face,
the top face being an aspheric surface rotational symmetric with respect to the z-axis and which totally reflects a part of a ht component, whose polar angle is smaller than a polar angle $\Theta_0$ at the intersection between the lateral and top faces, of light emitted at a half of a whole solid angle from the surface light source, and
the lateral face being an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source,
a function $r = f_s(z)$ where $\underline{z}$ is a variable representing the aspheric lateral face increasing monotonously as the $\underline{\text{variable } z}$ decreases in a closed zone defined by $0 \le z \le z_1$ when the z-coordinate of the intersection between the lateral and top faces is $z_1$, and having at least one point where an absolute value $|d^2r/dz^2|$ of a second-order differential coefficient of the $\underline{\text{variable } z}$ takes a maximum value in the closed zone.

**27.** A surface light source device including a plurality of light-emitting element assemblies to emit red light, a plurality of light-emitting element assemblies to emit green light and a plurality of light-emitting element assemblies to emit blue light, wherein
each of the light-emitting element assemblies includes
a lens formed from circular bottom, lateral and top faces, and
a surface light source formed from a light emitting element provided at the center of the bottom face of the lens,
in a cylindrical coordinate $(r, \phi, z)$ assumed for the lens and of which the origin is the center of the bottom face and z-axis is a normal line passing through the center of the bottom face,
the top face being an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and
the lateral face being an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source.

**28.** The surface light source device of claim 27, wherein the center of the bottom face is positioned nearly at the focal distance of the lateral face that effectively functions as a convex lens.

**29.** A surface light source device to backlight a transparent or semitransparent type color liquid crystal display, the device comprising:

a plurality of light-emitting element assemblies to emit red light, a plurality of light-emitting element assemblies to emit green light and a plurality of light-emitting element assemblies to emit blue light;

each of the light-emitting element assemblies including

a lens having circular bottom, lateral and top faces, and

a light emitting element provided at the center of the bottom face of the lens,

of the lens, the lateral face of the lens being a curved surface convexed outwardly and symmetric with respect to an axis of revolution which is an axis passing through the center point of the bottom face and perpendicular to the bottom face, and

the top face being a curved surface convexed toward the bottom face and symmetric with respect to the axis of revolution,

on the assumption that the cone angle of a first virtual cone having the vertex thereof defined by the center point and being tangent to the top face is $\Omega_1$ and the cone angle (solid angle) of a second virtual cone having the vertex thereof defined by the center point and being tangent to the top face is $\Omega_2$,

a component, existing inside the second virtual cone, of virtual light assumed to have been projected from the center point being projected from the top face to outside,

a component, existing outside the second virtual cone but inside the first virtual cone, of the virtual light assumed to have been projected from the center point being totally reflected at the top face and projected to outside from the lateral face, and

a component, existing outside the first virtual cone, of the virtual light assumed to have been projected from the center point being projected from the lateral face to outside.

30. A color liquid crystal display assembly including a transparent or semitransparent type color liquid crystal display and a surface light source device to backlight the color liquid crystal display, wherein

the surface light source device includes a plurality of light-emitting element assemblies to emit red light, a plurality of light-emitting element assemblies to emit green light and a plurality of light-emitting element assemblies to emit blue light, wherein

each of the light-emitting element assemblies includes

a lens formed from circular bottom, lateral and top faces, and

a surface light source formed from a light emitting element provided at the center of the bottom face thereof,

in a cylindrical coordinate $(r, \phi, z)$ assumed for the lens and of which the origin is the center of the bottom face and z-axis is a normal line passing through the center of the bottom face,

the top face being an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and

the lateral face being an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source,

a function $r = f_s(z)$ where $\underline{z}$ is a variable representing the aspheric lateral face increasing monotonously as the variable $\underline{z}$ decreasing in a closed zone defined by $0 \le z \le z_1$ when the z-coordinate of the intersection between the lateral and top faces is $z_1$, and having at least one point where an absolute value $|d^2r/dz^2|$ of a second-order differential coefficient of the $\underline{\text{variable } z}$ taking a maximum value in the closed zone.

31. A color liquid crystal display assembly including a transparent or semitransparent type color liquid crystal display and a surface light source device to backlight the color liquid crystal display to emit red light, a plurality of light-emitting element assemblies to emit green light and a plurality of light-emitting element assemblies to emit blue light, wherein

each of the light-emitting element assemblies includes

a lens formed from circular bottom, lateral and top faces, and

a surface light source formed from a light emitting element provided at the center of the bottom face thereof,

in a cylindrical coordinate $(r, \phi, z)$ assumed for the lens and of which the origin is the center of the bottom face and z-axis is a normal line passing through the center of the bottom face,

the top face being an aspheric surface rotational symmetric with respect to the z-axis and which totally reflects a part of a component, whose polar angle is smaller than a polar angle $\Theta_0$ at the intersection between the lateral and top faces, of light emitted at a half of a whole solid angle from the surface light source, and

the lateral face being an aspheric surface rotational symmetric with respect to the z-axis and pervious to a component, whose polar angle is larger than the polar angle $\Theta_0$, and component, totally reflected at the top face, of light emitted at the half of the whole solid angle from the surface light source.

**32.** The color liquid crystal display assembly of claim 31, wherein the center of the bottom face is positioned nearly at the focal distance of the lateral face that effectively functions as a convex lens.

**33.** A color liquid crystal display assembly including a transparent or semitransparent type color liquid crystal display and a surface light source device to backlight the color liquid crystal display, wherein

the surface light source device includes a plurality of light-emitting element assemblies to emit red light, a plurality of light-emitting element assemblies to emit green light and a plurality of light-emitting element assemblies to emit blue light, and

each of the light-emitting element assemblies includes

a lens formed from circular bottom, lateral and top faces, and

a light emitting element provided at the center of the bottom face thereof,

of the lens, the lateral face being a curved surface convexed outwardly and symmetric with respect to an axis of revolution which is an axis passing through the center point of the bottom face and perpendicular to the bottom face, and

the top face being a curved surface convexed toward the bottom face and symmetric with respect to the axis of revolution, and

on the assumption that the cone angle of a first virtual cone having the vertex thereof defined by the center point and being tangent to the top face is $\Omega_1$ and the cone angle (solid angle) of a second virtual cone having the vertex thereof defined by the center point and being tangent to the top face is $\Omega_2$,

a component, existing inside the second virtual cone, of virtual light assumed to have been projected from the center point being projected from the top face to outside,

a component, existing outside the second virtual cone but inside the first virtual cone, of the virtual light assumed to have been projected from the center point being totally reflected at the top face and projected to outside from the lateral face, and

a component, existing outside the first virtual cone, of the virtual light assumed to have been projected from the center point being projected from the lateral face to outside.

**FIG.1**

EP 1 818 706 A1

**FIG.3**

**FIG.4A**

**FIG.4B**

## FIG.5A

## FIG.5B

# FIG.6A

# FIG.6B

70

1G 1B 1G
1R 1R

**FIG.7A**

70
75A
76
40
75B
84
73
75C
83
77
81
82
72B
74
1G 1R 1B
71
72A
85

**FIG.7B**

**FIG.8**

FIG.9A

FIG.9B

FIG.10

EP 1 818 706 A1

**FIG.11**

EP 1 818 706 A1

EP 1 818 706 A1

Spherical surface

Aspheric surface

**FIG.12**

FIG.13

EP 1 818 706 A1

Directly
transmitted
light

Light
transmitted
after totally
reflected

FIG.14

FIG.15

FIG.16

**FIG.17A**

**FIG.17B**

FIG.18

FIG.19

EP 1 818 706 A1

$y = -108.89\,x^2 + 134.72\,x - 32.416$

$R^2 = 1$

## FIG.20

EP 1 818 706 A1

Size of surface light source d/2 (= 0.6 mm)

$$y = -181.9 \, x^2 + 5.9954 \, x + 9.2171$$
$$R^2 = 1$$

**FIG.21**

EP 1 818 706 A1

FIG.22

# FIG.23

FIG.24A

FIG.24B

FIG.25

**FIG.26A**

**FIG.26B**

Procedure for production of light-emitting element assembly

Monomer

Production of light
lead-out lens

↓

Forming by injection
molding

10

↓

Application of
adhesive

10

13

Production of
light-emitting
element

20

26

Assembling

10

20      26

Curing of adhesive

10

20      26

FIG.27

**FIG.28A**

**FIG.28B**

Graph with c = 1.4 and e = 1.48

In this case, a=0.6
and upper focus (0,0.888)
and lower focus (0,−0.888)
are selected.

$$z = \frac{cr^2}{1+\sqrt{1-c^2r^2(1-e^2)}} + \frac{1}{c(e^2-1)}$$

Asymptote

$$z = \frac{1}{\sqrt{e^2-1}}r$$

Focus $= \dfrac{e}{c(e^2-1)}$

$a = \dfrac{1}{c(e^2-1)}$

Lower focus

$$z = \frac{-cr^2}{1+\sqrt{1-c^2r^2(1-e^2)}} - \frac{1}{c(e^2-1)}$$

$$z = -\frac{1}{\sqrt{e^2-1}}r$$

## FIG.29

**FIG.30A**

**FIG.30B**

## INTERNATIONAL SEARCH REPORT

International application No.

PCT/JP2005/022215

A. CLASSIFICATION OF SUBJECT MATTER

*G02B13/00*(2006.01), *G02B3/02*(2006.01), *G02B13/18*(2006.01), *G02F1/13357*
(2006.01), *H01L33/00*(2006.01)

According to International Patent Classification (IPC) or to both national classification and IPC

B. FIELDS SEARCHED

Minimum documentation searched (classification system followed by classification symbols)
*G02B13/00*(2006.01), *G02B3/02*(2006.01), *G02B13/18*(2006.01), *G02F1/13357*
(2006.01), *H01L33/00*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-332630 A (Toyoda Gosei Co., Ltd.),<br>21 November, 2003 (21.11.03),<br>Par. Nos. [0028] to [0030], [0035] to [0036],<br>[0054] to [0055]; Figs. 2, 9, 10<br>& WO 03/049207 A1   & EP 1453107 A1 | 1-16<br>17-33 |
| Y | JP 2004-319458 A (Fujitsu Display Technologies<br>Kabushiki Kaisha),<br>11 November, 2004 (11.11.04),<br>Claims; Figs. 10, 14, 21<br>& US 2004/0218388 A1 | 17-33 |

☐ Further documents are listed in the continuation of Box C.    ☐ See patent family annex.

| | |
|---|---|
| *   Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>20 March, 2006 (20.03.06) | Date of mailing of the international search report<br>28 March, 2006 (28.03.06) |
|---|---|
| Name and mailing address of the ISA/<br>    Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004352027 A
- JP 2005133677 A
- JP 2005260908 A

**Non-patent literature cited in the description**

- *Nikkei Electronics,* 20 December 2004, vol. 889, 128
- **RUDOLF KINGSLAKE.** Lens Design Fundamentals. Academic Press, 1978, 304
- *Nikkei Electronics,* 20 December 2004, 128